# EUROPEAN PATENT APPLICATION

(11) **EP 4 753 436 A1**
(43) Date of publication of application: **03.06.2026**
(21) Application number: 25188535.6
(22) Date of filing: 09.07.2025
(51) Int. Cl.: H10P 74/00

(54) **SEMICONDUCTOR DEVICE**

(30) Priority: 28.11.2024 KR 20240174072
(71) Applicant: Samsung Electronics Co., Ltd., Suwon-si, Gyeonggi-do 16677 (KR)
(72) Inventor: SONG, Inhyun, Suwon-si (KR); LEE, Kyoungwoo, Suwon-si (KR); CHUNG, Myungjin, Suwon-si (KR); CHUNG, Eunguk, Suwon-si (KR); JEONG, Hoyeong, Suwon-si (KR); CHO, Keun Hwi, Suwon-si (KR); HEO, Suhaeng, Suwon-si (KR)
(74) Representative: Marks & Clerk LLP

(57) **Abstract**

A semiconductor device includes a substrate including a first surface and a second surface that are opposite to each other, a cell region, and a keep out region, an activation pattern, a dummy pattern, source/drain patterns and dummy source/drain patterns, gate electrodes, dummy gate electrodes, an upper wire that is connected to at least one first source/drain pattern of the source/drain patterns, a lower wire that is connected to at least one second source drain/pattern of the source/drain patterns, and a dummy wiring extending from one of the upper wire or the lower wire, where the dummy gate electrodes and the dummy source/drain patterns are insulated from the upper wire and the lower wire, and where ends of the dummy wiring are on the keep out region.

## Description

### TECHNICAL FIELD

The present disclosure relates to a semiconductor device.

### BACKGROUND

Recently, as an integration and miniaturization of semiconductor devices are accelerating, it is becoming more desirable to improve a performance of devices and ensure stability. Although various process technologies and design techniques are being introduced for this purpose, semiconductor devices may still be defective due to physical and chemical stress or process deviation. Therefore, it is desirable to analyze the causes of defects in the semiconductor devices, optimize the process and design, and ensure a product quality and reliability.

A failure analysis (FA) is an analysis procedure performed to identify the cause of such defects, and it may be conducted through electric characteristic analysis, observations using a scanning electron microscope (SEM), and a layer removal process (e.g., a delayering). Among them, the layer removal process (the delayering) is a method of observing the internal structure by removing the layers one layer at a time from the upper to lower layers of the device, and is widely used as a method for accurately analyzing defects in each layer.

However, the process of connecting electrodes such as a source, a drain, and a gate into a single analysis circuit network may require highly precise technology, and it is desirable to maintain the connection while removing each layer in particular. Against this backdrop, research is actively being conducted on methods to connect the source, the drain, and the gate and maintain electric characteristics even after the layer removal process (the delayering).

### SUMMARY

Embodiments of the present disclosure maintain electric characteristics even after the layer removal process (the delayering) for defect analysis.

A semiconductor device according to some embodiments includes a substrate that includes a first surface and a second surface that are opposite to each other, a cell region, and a keep out region, an activation pattern and a dummy pattern that are spaced apart from each other in a first direction and are on the first surface of the substrate, source/drain patterns and dummy source/drain patterns connected to the activation pattern and the dummy pattern, respectively, gate electrodes and dummy gate electrodes that extend around the activation pattern and the dummy pattern, respectively, and extend in a second direction intersecting the first direction, an upper wire that is on the first surface of the substrate, is on the cell region, and is connected to at least one first source/drain pattern of the source/drain patterns, a lower wire that is on the second surface of the substrate, is on the cell region, and is connected to at least one second source drain/pattern of the source/drain patterns, and a dummy wiring extending from one of the upper wire or the lower wire, where the dummy gate electrodes and the dummy source/drain patterns are insulated from the upper wire and the lower wire, and where ends of the dummy wiring are on the keep out region.

A semiconductor device according to some embodiments includes a substrate that includes a first surface and a second surface that are opposite to each other, a cell region, and a keep out region, an activation pattern and a dummy pattern that are spaced apart from each other in a first direction and are on the first surface of the substrate, source/drain patterns and dummy source/drain patterns connected to the activation pattern and the dummy pattern, respectively, gate electrodes and dummy gate electrodes that extend around the activation pattern and the dummy pattern, respectively, and extend in a second direction intersecting the first direction, an upper wire that is on the first surface of the substrate, is on the cell region, and is connected to at least one first source/drain pattern of the source/drain patterns, a lower wire that is on the second surface of the substrate, is on the cell region, and is connected to at least one second source/drain pattern of the source/drain patterns, and a dummy wiring extending from one of the upper wire or the lower wire, where the dummy gate electrodes and the dummy source/drain patterns are insulated from the upper wire and the lower wire, and where the dummy wiring extends into the keep out region.

A semiconductor device according to some embodiments includes a substrate including a first surface and a second surface that are opposite to each other, a first element region, a second element region, and a dummy region between the first element region and the second element region, a first activation pattern, a second activation pattern, and a dummy pattern that are spaced apart from each other in a first direction and are on the first surface of the first element region, the second element region, and the dummy region of the substrate, respectively, first source/drain patterns, second source/drain patterns, and dummy source/drain patterns that are connected to the first activation pattern, the second activation pattern, and the dummy pattern, respectively, first gate electrodes, second gate electrodes, and dummy gate electrodes that extend around the first activation pattern, the second activation pattern, and the dummy pattern, respectively, and extend in a second direction intersecting the first direction, an upper wire that is on the first surface of the substrate and is connected to a first set of the first source/drain patterns and a first set of the second source/drain patterns, a lower wire that is on the second surface of the substrate and is connected to a second set of the first source/drain patterns and a second set of the second source/drain patterns, and a dummy wiring extending from one of the upper wire or the lower wire, where the dummy gate electrodes and the dummy source/drain patterns are insulated from the upper wire and the lower wire on a portion of the dummy region, and where the dummy wiring crosses the portion of the dummy region in the first direction and is connected to at least one of the first source/drain patterns and at least one of the second source/drain patterns.

According to embodiments, a layer removal process (a delayering) for a failure analysis may be performed while maintaining the electric characteristics of the semiconductor device.

At least some of the above and other features of the invention are set out in the claims.

### BRIEF DESCRIPTION OF THE DRAWINGS

FIG. 1 is a top plan view of a semiconductor wafer on which a semiconductor device is formed according to some embodiments.
FIG. 2 is an enlarged view of a region M of FIG. 1.
FIG. 3 is a cross-sectional view taken along a line A-A' of FIG. 2 according to some embodiments.
FIG. 4 is a cross-sectional view taken along a line B-B' of FIG. 2 according to some embodiments.
FIG. 5 to FIG. 7 are cross-sectional views illustrating a method for performing a failure analysis according to some embodiments.
FIG. 8 is a cross-sectional view taken along a line A-A' of FIG. 2 according to some embodiments.
FIG. 9 is a cross-sectional view taken along a line B-B' of FIG. 2 according to some embodiments.
FIG. 10 is a cross-sectional view taken along a line A-A' of FIG. 2 according to some embodiments.
FIG. 11 is a cross-sectional view taken along a line B-B' of FIG. 2 according to some embodiments.
FIG. 12 is a cross-sectional view taken along a line A-A' of FIG. 2 according to some embodiments.
FIG. 13 is a cross-sectional view taken along a line B-B' of FIG. 2 according to some embodiments.
FIG. 14 is a top plan view showing a semiconductor device according to some embodiments.
FIG. 15 is an enlarged view of a region N of FIG. 14 according to some embodiments.
FIG. 16 is a cross-sectional view taken along a line A-A' of FIG. 15 according to some embodiments.
FIG. 17 is a cross-sectional view taken along a line A-A' of FIG. 2 according to some embodiments.
FIG. 18 is a cross-sectional view taken along a line B-B' of FIG. 2 according to some embodiments.
FIG. 19 is an enlarged view of a region N of FIG. 14 according to some embodiments.
FIG. 20 is a cross-sectional view taken along a line A-A' of FIG. 15 according to some embodiments.
FIG. 21 is a cross-sectional view taken along a line B-B' of FIG. 15 according to some embodiments.

### DETAILED DESCRIPTION

The present disclosure will be described more fully hereinafter with reference to the accompanying drawings, in which example embodiments of the disclosure are shown. As those skilled in the art would realize, the described embodiments may be modified in various different ways, all without departing from the scope of the present disclosure.

Descriptions of parts not related to the present disclosure are omitted, and like reference numerals designate like elements throughout the specification.

Further, since sizes and thicknesses of constituent members shown in the accompanying drawings are arbitrarily given for better understanding and ease of description, the present disclosure is not limited to the illustrated sizes and thicknesses. In the drawings, the thickness of layers, films, panels, regions, etc., are exaggerated for clarity. In the drawings, for better understanding and ease of description, the thicknesses of some layers and areas are exaggerated.

It will be understood that when an element such as a layer, film, region, or substrate is referred to as being "on" another element, it can be directly on the other element or intervening elements may also be present. In contrast, when an element is referred to as being "directly on" another element, there are no intervening elements present. Further, in the specification, the word "on" or "above" means positioned on or below the object portion, and does not necessarily mean positioned on the upper side of the object portion based on a gravitational direction.

In addition, unless explicitly described to the contrary, the word "comprise", and variations such as "comprises" or "comprising", will be understood to imply the inclusion of stated elements but not the exclusion of any other elements. As used herein, the singular forms "a," "an" and "the" are intended to include the plural forms as well, unless the context clearly indicates otherwise. The term "and/or" includes any and all combinations of one or more of the associated listed items. The term "connected" may be used herein to refer to a physical and/or electrical connection and may refer to a direct or indirect physical and/or electrical connection. Components or layers described with reference to "overlap" in a particular direction may be at least partially obstructed by one another when viewed along a line extending in the particular direction or in a plane perpendicular to the particular direction. The terms "first," "second," etc. may be used herein to merely distinguish one component, element, etc., from another. Numerical labels (such as "first", "second") that are used to distinguish components need not imply any particular order or arrangement.

Further, throughout the specification, the phrase "on a plane" means viewing a target portion from the top, and the phrase "on a cross-section" means viewing a cross-section formed by vertically cutting a target portion from the side.

Additionally, throughout the specification, two directions parallel to and intersecting an upper surface of a substrate are defined as a first direction D1 and a second direction D2, respectively, and a direction perpendicular to the upper surface of the substrate is described as a third direction D3. The first direction D1 and the second direction D2 may be parallel to the upper surface of the substrate and the third direction D3 may be perpendicular to the upper surface of the substrate. For example, the first direction D1 and the second direction D2 may be orthogonal to each other. The third direction D3 may define a vertical or height direction. Certain features or elements that are located further along the third direction D3 than other features or elements may be described as "above" the other features or elements. Nevertheless, it will be appreciated that the directions defined herein are defined relative to the structure of the device, and therefore do not necessarily imply any particular orientation of the device in use.

In a drawing of a semiconductor device according to some embodiments, GAA (Gate All Around) and MBCFET^{™} (Multi-Bridge Channel Field Effect Transistor) including nano wires or nano sheets are illustrated as examples, but are not limited thereto. According to some embodiments, the semiconductor device may include a fin-type transistor (FinFET) including a channel region of a fin-type pattern shape, a tunneling transistor (a tunneling FET), a 3D-SFET (3D Stack Field Effect Transistor) structure, and a CFET (Complementary Field Effect Transistor) structure.

Below, the semiconductor device according to some embodiments of the present disclosure may be used in various memory devices and systems including a wiring structure. For example, the semiconductor device may be applied to a wiring structure included in a logic device such as a central processing unit (CPU, MPU), an application processor (AP), etc. In some embodiments, the semiconductor device may be applied to a wiring structure used in a memory peripheral circuit region or a cell region of a volatile memory device such as a DRAM device or an SRAM device, or a non-volatile memory device such as a flash memory device, a PRAM device, an MRAM device, or an RRAM device.

Below, the semiconductor device according to some embodiments is described with reference to accompanying drawings.

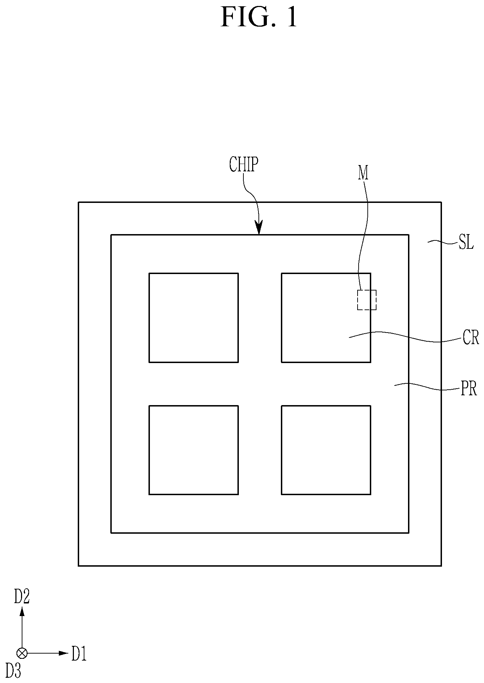

FIG. 1 is a top plan view of a semiconductor wafer on which a semiconductor device is formed according to some embodiments.

Referring to FIG. 1, a semiconductor wafer may include semiconductor chip regions CHIP and scribe lane regions SL between the semiconductor chip regions CHIP. Additionally, the semiconductor chip region CHIP may include a cell region CR and a peripheral region PR. In other words, one or more cell regions CR and peripheral regions PR may form one semiconductor chip region CHIP, and the scribe lane region SL may be arranged to surround or extend around the semiconductor chip region CHIP. Logic transistors that constitute or are included in the logic circuit of the semiconductor device may be placed in or on the cell region CR. Transistors that constitute or are included in a processor core or an I/O terminal of the cell region CR may be placed in or on the peripheral region PR.

Although FIG. 1 illustrates that the peripheral region PR surrounds or extends around the cell region CR, the present disclosure is not limited to this arrangement, and the cell region CR and the peripheral region PR may have any suitable arrangement. According to some embodiments, at least a portion of the peripheral region PR may be placed within or on the cell region CR. Additionally, the number of the cell regions CR forming one semiconductor chip region CHIP is not limited to that shown.

The scribe lane regions SL correspond to the region for performing a dicing process, which separates the semiconductor wafer into individual semiconductor chips, after forming the semiconductor devices in the semiconductor chip region CHIP. Although not shown, the scribe lane regions SL may include a key region. The key region may include align keys or overlay keys used in exposure processes performed to form the semiconductor device on the semiconductor chip region CHIP.

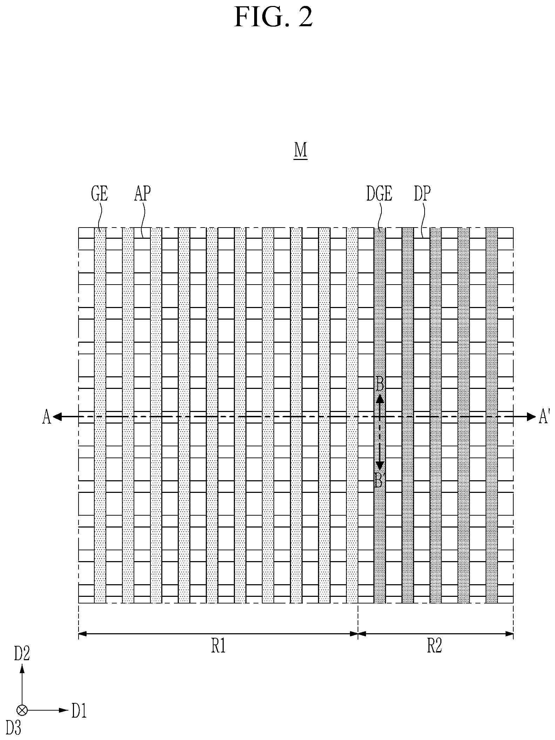

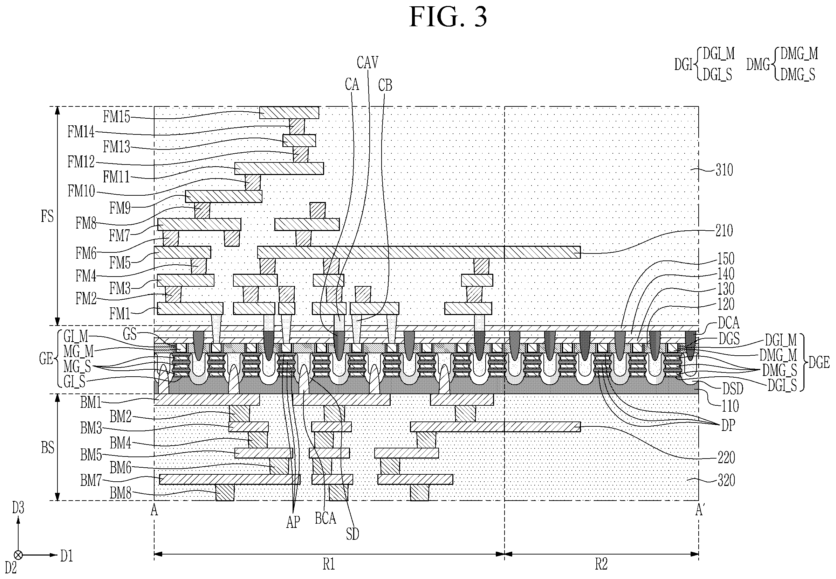

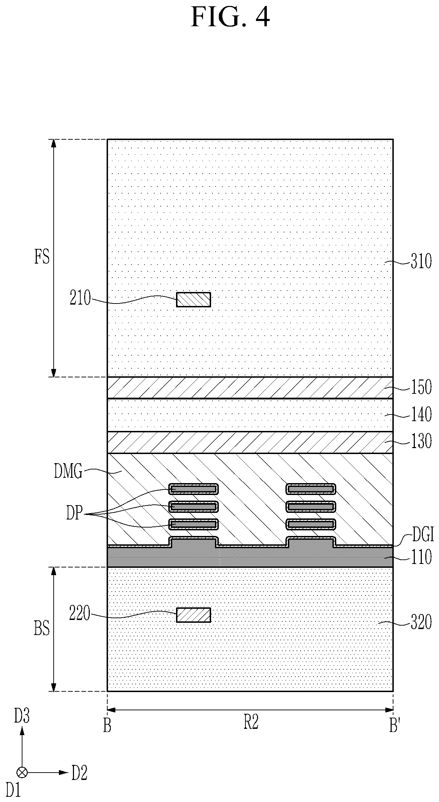

FIG. 2 is an enlarged view of a region M of FIG. 1. FIG. 3 is a cross-sectional view taken along a line A-A' of FIG. 2 according to some embodiments. FIG. 4 is a cross-sectional view taken along a line B-B' of FIG. 2 according to some embodiments.

Referring to FIG. 2 to FIG. 4, a substrate 110 including a first region R1 and a second region R2 may be provided. According to some embodiments, the first region R1 may be any region among the cell regions CR of FIG. 1, and the second region R2 may be any region among the peripheral regions PR of FIG. 1. In the present disclosure, the first region R1 may correspond to a region including electrically active transistors, and the second region R2 may correspond to a region including electrically inactive transistors. An electrically inactive transistor may be a transistor that is not electrically connected to other circuitry (e.g. is not connected to wiring such as upper and/or lower wiring).

In the present disclosure, the second region R2 may be referred to as a keep out zone or keep out region. The keep-out zone may mean a region designed so that a wiring is not intentionally connected to a transistor.

According to some embodiments, the substrate 110 may be an insulation substrate including an insulating material. The substrate 110 may include oxide, nitride, oxynitride, or a combination thereof. For example, the substrate 110 may include silicon nitride (SiNx). In some embodiments, the substrate 110 may be a semiconductor substrate including a semiconductor material. For example, the substrate 110 may include silicon, germanium, or silicon-germanium. Accordingly, the lower contact pattern BCA and the first lower wire pattern BM1 may be in contact with the substrate 110 including an insulating material. In other words, the substrate 110 surrounding or extending around the lower contact pattern BCA may be an insulating material. If the substrate 110 includes a semiconductor material, it may not be in contact with the lower contact pattern BCA and the first lower wire pattern BM1. Accordingly, a separate insulation layer may be provided between the substrate 110 and the lower contact pattern BCA, and between the substrate 110 and the first lower wire pattern BM1. Although the substrate 110 is depicted as a single film, this is only for better understanding and ease of explanation and is not limited thereto.

According to some embodiments, the first surface and the second surface of the substrate 110 may be formed as planes parallel to the first direction D1 and the second direction D2 intersecting the first direction D1. For example, the first surface of substrate 110 may be the upper surface, and the second surface may be the lower surface. The upper surface of the substrate 110 is a surface opposite to the lower surface of substrate 110 in the third direction D3. The third direction D3 may be a direction perpendicular to the first direction D1 and the second direction D2. The lower surface of the substrate 110 may be referred to as a back side of the substrate 110. In some embodiments, the logic circuit of the cell region may be implemented on the upper surface of the substrate 110. In some embodiments, the upper wire region FS may be positioned on the upper surface of the substrate 110. In some embodiments, the lower wire region BS may be positioned on the lower surface of the substrate 110.

According to some embodiments, the semiconductor device may include, in the first region R1, an activation pattern AP spaced apart along the first direction D1 on the first surface of the substrate 110, source/drain patterns SD connected to both sides of the activation pattern AP, and a gate structure GE surrounding or extending around the activation pattern AP and extending in the second direction D2. The activation pattern AP may be otherwise known as an active pattern AP. The activation pattern AP may form a channel region within a respective transistor. The activation pattern AP may be otherwise known as a channel pattern.

According to some embodiments, the semiconductor device may include, in or on the second region R2, a dummy pattern DP spaced apart along the first direction D1 on the first surface of the substrate 110, dummy source/drain patterns DSD connected to both sides of the dummy pattern DP, and a dummy gate structure DGE extending in the second direction D2 surrounding or extending around the dummy pattern DP.

According to some embodiments, the activation patterns AP may be arranged spaced apart in the first direction D1 on the first region R1 of the substrate 110. According to some embodiments, the plurality of activation patterns AP may be arranged spaced apart from each other in the third direction D3.

According to some embodiments, each of the plurality of activation patterns AP may have a sheet shape. A plurality of activation patterns AP each may be a nano sheet with a thickness of several nanometers along the third direction D3.

According to some embodiments, the activation pattern AP may provide a passage for a current to flow between the source/drain patterns SD described below. For example, the activation pattern AP may be placed between the source/drain patterns SD and connect the source/drain patterns SD. For example, the activation pattern AP may be configured to form a channel between the source/drain patterns SD to connect the source/drain patterns SD, dependent on a voltage of the gate structure GE surrounding or extending around the activation.

According to some embodiments, the activation pattern AP may penetrate or extend into a part of a gate structure GE, which will be described later, in a direction (e.g., the first direction D1) that intersects a direction in which the gate structure GE extends. In FIG. 3, three activation patterns AP are shown arranged spaced apart in the third direction D3, but this is not limited to the arrangement, and the number of stacks of the activation patterns AP may be changed in various ways.

Referring to FIG. 3 and FIG. 4, the dummy patterns DP may be arranged spaced apart in the first direction D1 on the second region R2 of the substrate 110. According to some embodiments, the plurality of dummy patterns DP may be arranged spaced apart from each other in the third direction D3.

According to some embodiments, the plurality of dummy patterns DP may have a sheet shape. The plurality of dummy patterns DP may be a nano sheet with a thickness of several nanometers along the third direction D3.

According to some embodiments, the dummy pattern DP may penetrate or extend into a part of a dummy gate structure DGE described later in a direction (e.g., the first direction D1) that intersects the direction in which the dummy gate structure DGE extends. In FIG. 3 and FIG. 4, three dummy patterns DP are shown arranged spaced apart in the third direction D3, but this is not limited to the arrangement, and the number of stacks of the dummy patterns DP may be changed in various ways.

According to some embodiments, the activation patterns AP and the dummy patterns DP may include a semiconductor material. For example, the activation patterns AP and the dummy patterns DP may include Group IV semiconductors such as Si, Ge, Group III-V compound semiconductors, Group II-VI compound semiconductors, etc.

According to some embodiments, the gate structure GE and the dummy gate structure DGE may be positioned on the first region R1 and the second region R2 of the substrate 110, respectively. According to some embodiments, the gate structure GE and the dummy gate structure DGE may extend in the second direction D2 on the first region R1 and the second region R2 of the substrate 110, respectively. The gate structures GE and the dummy gate structures DGE may be arranged spaced apart from each other in the first direction D1.

According to some embodiments, the gate structure GE may include a plurality of sub-gate structures MG_S and GI_S and a main gate structure MG_M and GI_M. The sub-gate structures MG_S and GI_S may be positioned on the first region R1 of the substrate 110, and the main gate structure MG_M and GI_M may be positioned on the sub-gate structures MG_S and GI_S.

Each of the sub-gate structures MG_S and GI_S may be composed of multiple layers. For example, each of the sub-gate structures MG_S and GI_S may include a sub-gate electrode MG_S and a sub-gate insulation layer GI_S.

According to some embodiments, the dummy gate structure DGE may include a plurality of dummy sub-gate structures DMG_S and DGI_S and a dummy main gate structure DMG_M and DGI_M. The dummy sub-gate structure DMG_S and DGI_S may be positioned on the second region R2 of the substrate 110, and the dummy main gate structure DMG_M and DGI_M may be positioned on the dummy sub-gate structure DMG_S and DGI_S.

Each of the dummy sub-gate structures DMG_S and DGI_S may be composed of multiple layers. For example, each of the dummy sub-gate structures DMG_S and DGI_S may include a dummy sub-gate electrode DMG_S and a dummy sub-gate insulation layer DGI_S.

According to some embodiments, in the first region R1, the sub-gate structures MG_S and GI_S and the activation patterns AP may be alternately stacked in the third direction D3. According to some embodiments, in or on the second region R2, the dummy sub-gate structures DMG_S and DGI_S and the dummy patterns DP may be alternately stacked in the third direction D3.

In FIG. 3, three sub-gate structures MG_S and GI_S are depicted as arranged spaced apart in the third direction D3, but the number of the sub-gate structures MG_S and GI_S arranged spaced apart is not limited to this. For example, the gate structure GE may include four sub-gate structures MG_S and GI_S. In FIG. 3 and FIG. 4, three dummy sub-gate structures DMG_S and DGI_S are depicted as arranged spaced apart in the third direction D3, but the number of the dummy sub-gate structures DMG_S and DGI_S arranged spaced apart is not limited to this. For example, the dummy gate structure DGE may include four dummy sub-gate structures DMG_S and DGI_S.

According to some embodiments, the sub-gate electrodes MG_S and the dummy sub-gate electrodes DMG_S may be positioned on the first and second regions R1 and R2 of the substrate 110, respectively. According to some embodiments, the sub-gate electrodes MG_S in the first region R1 may surround or extend around the activation patterns AP. In the second region R2, the dummy sub-gate electrodes DMG_S may surround or extend around the dummy patterns DP.

The sub-gate electrodes MG_S and the dummy sub-gate electrodes DMG_S may include at least one of a metal, a metal alloy, a conductive metal nitride, a metal silicide, a doped semiconductor material, a conductive metal oxide, and a conductive metal oxynitride. The sub-gate electrodes MG_S and the dummy sub-gate electrodes DMG_S, for example, may include at least one among titanium nitride (TiN), tantalum carbide (TaC), tantalum nitride (TaN), titanium silicon nitride (TiSiN), tantalum silicon nitride (TaSiN), tantalum titanium nitride (TaTiN), titanium aluminum nitride (TiAlN), tantalum aluminum nitride (TaAlN), tungsten nitride (WN), ruthenium (Ru), titanium aluminum (TiAl), titanium aluminum carbonization nitride (TiAlC-N), titanium aluminum carbide (TiAlC), titanium carbide (TiC), tantalum carbonization nitride (TaCN), tungsten (W), aluminum (Al), copper (Cu), cobalt (Co), titanium (Ti), tantalum (Ta), nickel (Ni), platinum (Pt), nickel platinum (Ni-Pt), niobium (Nb), niobium nitride (NbN), niobium carbide (NbC), molybdenum (Mo), molybdenum nitride (MoN), molybdenum carbide (MoC), tungsten carbide (WC), rhodium (Rh), palladium (Pd), iridium (Ir), osmium (Os), silver (Ag), gold (Au), zinc (Zn), vanadium (V), or a combination thereof, but it is not limited thereto. The conductive metal oxide and the conductive metal oxynitride may include an oxidized form of the material described above, but are not limited thereto.

The sub-gate insulation layer GI_S and the dummy sub-gate insulation layer DGI_S may extend along the upper surfaces of the first and second regions R1 and R2 of the substrate 110, respectively. The sub-gate insulation layer GI_S and the dummy sub-gate insulation layer DGI_S may be positioned along the circumference of the plurality of sub-gate electrodes MG_S and the plurality of dummy sub-gate electrodes DMG_S, respectively. The sub-gate insulation layer GI_S may be in contact with the upper surface of the substrate 110 and the plurality of activation patterns AP. The dummy sub-gate insulation layer DGI_S may be in contact with the upper surface of the substrate 110 and the plurality of dummy patterns DP. The sub-gate insulation layer GI_S may be interposed between the plurality of activation patterns AP and the plurality of sub-gate electrodes MG_S. The dummy sub-gate insulation layer DGI_S may be interposed between the plurality of dummy patterns DP and the plurality of dummy sub-gate electrodes DMG_S. According to some embodiments, the sub-gate insulation layer GI_S and the dummy sub-gate insulation layer DGI_S may each include various insulating materials.

Although not shown in FIG. 3 and FIG. 4, the semiconductor device according to some embodiments may further include an inner gate spacer positioned between the sub-gate insulation layer GI_S and a source/drain patterns SD described below. Additionally, although not shown in FIG. 3 and FIG. 4, the semiconductor device according to some embodiments may further include an inner gate spacer positioned between the dummy sub-gate insulation layer DGI_S and a dummy source/drain patterns DSD described below.

In some embodiments, the sub-gate insulation layer GI_S and the dummy sub-gate insulation layer DGI_S may be depicted as a single film, but is not limited thereto. For example, the sub-gate insulation layer GI_S and the dummy sub-gate insulation layer DGI_S may include silicon oxide, silicon oxidation nitride or silicon nitride. In some embodiments, for example, the sub-gate insulation layer GI_S and the dummy sub-gate insulation layer DGI_S may include a high dielectric constant material. In some embodiments, for example, the sub-gate insulation layer GI_S and the dummy sub-gate insulation layer DGI_S may include both silicon oxide and a high dielectric constant material. The high dielectric constant material may include a material with a higher dielectric constant than silicon oxide SiO2, such as hafnium oxide (HfO), aluminum oxide (AlO), or tantalum oxide (TaO).

According to some embodiments, the main gate structure MG_M and GI_M may be positioned on the sub-gate structures MG_S and GI_S and the plurality of activation patterns AP. The main gate structure MG_M and GI_M may be positioned on the upper surface of the activation pattern AP, which is positioned at the top among the plurality of activation patterns AP.

According to some embodiments, the dummy main gate structure DMG_M and DGI_M may be positioned on the dummy sub-gate structure DMG_S and DGI_S and the plurality of dummy patterns DP. The dummy main gate structure DMG_M and DGI_M may be positioned on the upper surface of the dummy pattern DP, which is positioned at the top among the plurality of dummy patterns DP.

Referring to FIG. 4, at least a portion of the dummy gate electrode DMG may be positioned on the structure in which the dummy sub-gate electrodes DMG_S and the dummy patterns DP are alternately stacked. Another portion of the dummy gate electrode DMG may be formed to cover or at least partially overlap both sides of the structure in which the dummy sub-gate electrodes DMG_S and the dummy patterns DP are alternately stacked. Accordingly, four surfaces of the plurality of dummy patterns DP may be at least partially surrounded by the dummy gate electrode DMG. Although not shown, four surfaces of AP may be at least partially surrounded by the gate electrode MG_M and MG_S in the first region R1.

According to some embodiments, the main gate structure MG_M and GI_M may include a main gate electrode MG_M and a main gate insulation layer GI_M. According to some embodiments, the dummy main gate structure DMG_M and DGI_M may include a dummy main gate electrode DMG_M and a dummy main gate insulation layer DGI_M.

According to some embodiments, the main gate electrode MG_M may be positioned on the sub-gate structures MG_S and GI_S and the plurality of activation patterns AP. According to some embodiments, the dummy main gate electrode DMG_M may be positioned on the dummy sub-gate structure DMG_S and DGI_S and the plurality of dummy patterns DP. The main gate electrode MG_M and the dummy main gate electrode DMG_M may each include the same material as the sub-gate electrodes MG_S and the dummy sub-gate electrodes DMG_S. For example, the main gate electrode MG_M and the dummy main gate electrode DMG_M may include at least one of a metal, a metal alloy, a conductive metal nitride, a metal silicide, a doped semiconductor material, a conductive metal oxide, or a conductive metal oxynitride.

According to some embodiments, the main gate insulation layer GI_M and the dummy main gate insulation layer DGI_M may extend along the side surface and lower surface of the main gate electrode MG_M and the dummy main gate electrode DMG_M, respectively. The main gate insulation layer GI_M and the dummy main gate insulation layer DGI_M may extend along side surfaces of a gate spacer GS and dummy gate spacer DGS, respectively, described below. The main gate insulation layer GI_M and the dummy main gate insulation layer DGI_M may each include various insulating materials.

In some embodiments, the main gate insulation layer GI_M and the dummy main gate insulation layer DGI_M are each depicted as a single film, but is not limited thereto. For example, the main gate insulation layer GI_M and the dummy main gate insulation layer DGI_M may be formed of multiple layers including silicon oxide (SiO₂) and a high dielectric constant material, respectively. Accordingly, the high dielectric constant material may include a material with a higher dielectric constant than silicon oxide (SiO₂), such as hafnium oxide (HfO), aluminum oxide (AlO), or tantalum oxide (TaO).

The semiconductor device according to some embodiments may further include a gate spacer GS and a dummy gate spacer DGS in the first region R1 and the second region R2, respectively.

According to some embodiments, the gate spacer GS and the dummy gate spacer DGS may be positioned on both sides of the main gate electrode MG_M and the dummy main gate electrode DMG_M, respectively. The gate spacer GS and the dummy gate spacer DGS may not be placed between the substrate 110 and the activation pattern AP and between the substrate 110 and the dummy pattern DP, respectively. According to some embodiments, the gate spacer GS and the dummy gate spacer DGS may not be placed between the plurality of activation patterns AP and the plurality of dummy patterns DP, which are adjacent in the third direction D3, respectively.

The gate spacer GS and the dummy gate spacer DGS may each include at least one of, for example, silicon nitride (SiN), silicon oxynitride (SiON), silicon oxide (SiO₂), silicon carbonate nitride (SiOCN), silicon boron nitride (SiBN), silicon oxide boron nitride (SiOBN), silicon oxide carbide (SiOC), or a combination thereof. The gate spacer GS is depicted as a single layer, but this is for better understanding and ease of description and is not limited thereto.

Referring to FIG. 3, the source/drain patterns SD and the dummy source/drain patterns DSD may be positioned on the first region R1 and the second region R2 of the substrate 110, respectively. According to some embodiments, the source/drain patterns SD and the dummy source/drain patterns DSD may be arranged spaced apart along the first direction D1 on the first region R1 and the second region R2 of the substrate 110, respectively. The activation pattern AP and the gate structure GE may be positioned between the source/drain patterns SD. The dummy pattern DP and the dummy gate structure DGE can be positioned between the dummy source/drain patterns DSD. In other words, the plurality of source/drain patterns SD and the plurality of activation patterns AP may be alternately arranged along the first direction D1 on the first region R1 of the substrate 110, and the plurality of dummy source/drain patterns DSD and the plurality of dummy patterns DP may be alternately arranged along the first direction D1 on the second region R2 of the substrate 110.

Although not shown, the source/drain patterns SD and the dummy source/drain patterns DSD may also be arranged in the second direction D2, respectively. The source/drain patterns SD and the dummy source/drain patterns DSD may be arranged spaced apart along the second direction D2 on the first region R1 and the second region R2 of the substrate 110, respectively.

According to some embodiments, in the first region R1, the source/drain pattern SD may be positioned on both sides of the activation patterns AP and/or the sub-gate structures MG_S and GI_S. Specifically, two source/drain patterns SD may be arranged with the activation patterns AP or the sub-gate structures MG_S and GI_S interposed between them in a direction (e.g., the first direction D1) intersecting the direction in which the gate structure GE extends. The upper surface of the source/drain pattern SD may be positioned at substantially the same level as the upper surface of the activation pattern AP relative to the lower surface of the substrate 110, which is positioned at the uppermost position among the activation patterns AP, but is not limited thereto. The source/drain pattern SD may be in contact with the activation pattern AP and the sub-gate structures MG_S and GI_S.

According to some embodiments, in the second region R2, the dummy source/drain pattern DSD may be positioned on both sides of the dummy patterns DP and/or the dummy sub-gate structure DMG_S and DGI_S. Specifically, two dummy source/drain patterns DSD may be arranged with the dummy patterns DP or the dummy sub-gate structures DMG_S and DGI_S interposed between them in the direction (e.g., the first direction D1) intersecting the direction in which the dummy gate structure DGE extends. The upper surface of the dummy source/drain pattern DSD may be positioned at substantially the same level as the upper surface of the dummy pattern DP relative to the lower surface of the substrate 110, which is positioned at the uppermost level among the dummy patterns DP relative to the lower surface of the substrate 110, but is not limited thereto. The dummy source/drain pattern DSD may be in contact with the dummy pattern DP and the dummy sub-gate structure DMG_S and DGI_S.

According to some embodiments, the side surfaces of the source/drain pattern SD and the dummy source/drain pattern DSD may have a nonlinear shape (e.g., an uneven embossed shape). In some embodiments, the sides of the source/drain pattern SD and the dummy source/drain pattern DSD may have a wavy profile. For example, the side of the source/drain pattern SD adjacent to the sub-gate structures MG_S and GI_S may have a convex shape toward the sub-gate structures MG_S and GI_S, and the side of the source/drain pattern SD adjacent to the activation patterns AP may have a concave shape toward the activation patterns AP. For instance, the side of the source/drain pattern SD may have protrusions, where each protrusion protrudes towards a corresponding sub-gate electrode MG_S, between adjacent activation patterns AP. Also, for example, the side surface of the dummy source/drain pattern DSD adjacent to the dummy sub-gate structures DMG_S and DGI_S may have a convex shape toward the dummy sub-gate structures DMG_S and DGI_S, and the side surface of the dummy source/drain pattern DSD adjacent to the dummy patterns DP may have a concave shape toward the dummy patterns DP. For instance, the side of the dummy source/drain pattern DSD may have protrusions, where each protrusion protrudes towards a corresponding dummy sub-gate electrode DMG_S, between adjacent dummy patterns DP.

According to some embodiments, the source/drain pattern SD and the dummy source/drain pattern DSD may be epitaxial patterns formed by a selective epitaxial growth process using the activation pattern AP and the dummy pattern DP as seeds, respectively. According to some embodiments, the source/drain pattern SD and the dummy source/drain patterns DSD may include Si or SiGe. However, the materials of the source/drain pattern SD and the dummy source/drain pattern DSD are not limited to this and may be changed in various ways. The source/drain pattern SD and the dummy source/drain pattern DSD may each serve as the source/drain of the transistor that uses the activation patterns AP and the dummy patterns DP as the channel region.

According to some embodiments, the source/drain pattern SD and the dummy source/drain pattern DSD may each include multiple layers. However, this is not limited to the above, and the source/drain pattern SD and the dummy source/drain pattern DSD may each be formed as a single layer.

According to some embodiments, the lower surfaces of the source/drain pattern SD and the dummy source/drain pattern DSD may be positioned at a lower level than the lower surfaces of the sub-gate structures MG_S and GI_S and the dummy sub-gate structures DMG_S and DGI_S, respectively, relative to the lower surface of the substrate 110. For example, as illustrated in FIG. 3, the lower surfaces of the source/drain pattern SD and the dummy source/drain pattern DSD may be positioned closer to the bottom surface of the substrate 110 than the lower surfaces of the sub-gate structures MG_S and GI_S and the dummy sub-gate structures DMG_S and DGI_S, which are positioned at the lowermost part, respectively.

According to some embodiments, the semiconductor device may further include a first interlayer insulating layer 120, a second interlayer insulating layer 130, a third interlayer insulating layer 140, and a fourth interlayer insulating layer 150. According to some embodiments, the semiconductor device may further include a contact pattern CA, a contact via CAV and a gate contact pattern CB on the first region R1 and a dummy contact pattern DCA on the second region R2.

According to some embodiments, the first interlayer insulating layer 120 may be positioned on the first region R1 and the second region R2 of the substrate 110. According to some embodiments, the first interlayer insulating layer 120 may cover or at least partially overlap the source/drain pattern SD and the dummy source/drain pattern DSD. Additionally, the first interlayer insulating layer 120 may be positioned between the main gate electrode MG_M and the contact pattern CA and between the dummy main gate electrode DMG_M and the dummy contact pattern DCA. For example, the first interlayer insulating layer 120 may be positioned between the gate spacer GS and the contact pattern CA and between the dummy gate spacer DGS and the dummy contact pattern DCA.

According to some embodiments, the first interlayer insulating layer 120 may include silicon oxide. Although the first interlayer insulating layer 120 is illustrated as a single film, it is not limited thereto, and the first interlayer insulating layer 120 may be formed of a multi-layer film in which a plurality of layers are laminated.

According to some embodiments, the second interlayer insulating layer 130 may be positioned on the first interlayer insulating layer 120. For example, the second interlayer insulating layer 130 may be positioned on the main gate electrode MG_M and the dummy main gate electrode DMG_M, and cover or at least partially overlap the main gate electrode MG_M and the dummy main gate electrode DMG_M. In other words, the second interlayer insulating layer 130 may replace a gate capping pattern and an upper insulating pattern.

According to some embodiments, the second interlayer insulating layer 130 may include silicon nitride. Although the second interlayer insulating layer 130 is illustrated as a single film, it is not limited thereto, and the second interlayer insulating layer 130 may be formed of a multi-layer film in which a plurality of layers are stacked.

According to some embodiments, the third interlayer insulating layer 140 may be positioned on the second interlayer insulating layer 130. Additionally, the third interlayer insulating layer 140 may be positioned between the contact pattern CA and the gate contact pattern CB and between the dummy contact patterns DCA. According to some embodiments, the third interlayer insulating layer 140 may include silicon oxide. Although the third interlayer insulating layer 140 is illustrated as a single film, it is not limited thereto, and the third interlayer insulating layer 140 may be formed of a multi-layer film in which a plurality of layers are stacked.

According to some embodiments, the fourth interlayer insulating layer 150 may be positioned on the third interlayer insulating layer 140. For example, the fourth interlayer insulating layer 150 may be positioned on the contact pattern CA and the dummy contact pattern DCA and cover or at least partially overlap the contact pattern CA and the dummy contact pattern DCA.

According to some embodiments, the fourth interlayer insulating layer 150 may have upper and lower portions facing away from each other in the third direction D3. The lower portion of the fourth interlayer insulating layer 150 is positioned closer to the substrate 110 than the upper portion. With the substrate 110 as a reference, the lower level of the fourth interlayer insulating layer 150 may be substantially the same as the upper level of the contact pattern CA and the dummy contact pattern DCA. In other words, the lower portion of the fourth interlayer insulating layer 150 and the upper portions of the contact pattern CA and the dummy contact pattern DCA may be positioned at the same level from or relative to the substrate 110 in the third direction D3.

According to some embodiments, the fourth interlayer insulating layer 150 may have a predetermined thickness along the third direction D3 from the upper portion of the contact pattern CA to a lower portion of an upper wire region FS described below. According to some embodiments, the fourth interlayer insulating layer 150 on the first region R1 of the substrate 110 may have penetration holes opened or extending in the third direction D3. In other words, the penetration holes on the first region R1 of the substrate 110 may penetrate or extend into the fourth interlayer insulating layer 150 from the lower portion to the upper portion in the third direction D3. According to some embodiments, the fourth interlayer insulating layer 150 on the second region R2 of the substrate 110 may not have penetration holes opened or extending in the third direction D3.

According to some embodiments, the contact via CAV and the gate contact pattern CB may be inserted (e.g. may penetrate) into the penetration holes of the fourth interlayer insulating layer 150. In other words, the penetration holes of the fourth interlayer insulating layer 150 may be arranged at the positions that at least partially overlap the contact via CAV and gate contact pattern CB in the third direction D3.

According to some embodiments, the width of the penetration holes into which the contact via CAV is inserted (e.g. penetrates) in the first direction D1 may be substantially the same as the maximum width of the contact pattern CA in the first direction D1. However, it is not limited thereto, and the width of the penetration holes into which the contact via CAV is inserted (e.g. penetrates) in the first direction D1 may be smaller than the maximum width of the contact pattern CA in the first direction D1. Additionally, the width of the penetration holes into which the gate contact pattern CB is inserted (e.g. penetrates) in the first direction D1 may be substantially the same as the maximum width of the main gate electrode MG_M in the first direction D1. However, it is not limited thereto, and the width of the penetration holes into which the gate contact pattern CB is inserted (e.g. penetrates) in the first direction D1 may be smaller than the maximum width of the main gate electrode MG_M in the first direction D1.

According to some embodiments, the fourth interlayer insulating layer 150 may include silicon nitride. Although the fourth interlayer insulating layer 150 is illustrated as a single film, it is not limited thereto, and the fourth interlayer insulating layer 150 may be formed of a multi-layer film in which a plurality of layers are stacked.

According to some embodiments, the contact pattern CA may be positioned on at least one of the source/drain patterns SD on the first region R1 of the substrate 110. According to some embodiments, the dummy contact pattern DCA may be positioned on at least one of the dummy source/drain pattern DSD on the second region R2 of the substrate 110.

According to some embodiments, the contact pattern CA may penetrate or extend into the first interlayer insulating layer 120, the second interlayer insulating layer 130 and the third interlayer insulating layer 140 and be connected to at least one of the source/drain patterns SD. According to some embodiments, the dummy contact pattern DCA may be connected to at least one of the dummy source/drain patterns DSD through the first interlayer insulating layer 120, the second interlayer insulating layer 130 and the third interlayer insulating layer 140.

According to some embodiments, the contact pattern CA and the dummy contact pattern DCA may be positioned adjacent to the main gate electrode MG_M and the dummy main gate electrode DMG_M in the first direction D1, respectively. According to some embodiments, the contact pattern CA may electrically connect at least some of upper wires FM1, FM2, FM3, FM4, FM5, FM6, FM7, FM8, FM9, FM10, FM11, FM12, FM13, FM14, and FM15 positioned in an upper wire region FS described below and at least one of the source/drain patterns SD. According to some embodiments, the dummy contact pattern DCA may not electrically connect the upper wires FM1 to FM15 which are positioned in the upper wire region FS and the dummy source/drain patterns DSD. In other words, the dummy source/drain patterns DSD may be electrically isolated from the upper wires FM1 to FM15.

According to some embodiments the contact pattern CA and the dummy contact pattern DCA may include at least one of a metal, a metal alloy, a conductive metal nitride, a conductive metal carbide, a conductive metal oxide, a conductive metal carbon nitride, or a two-dimensional material (two-dimensional 2D material). The metal may include at least one of titanium (Ti), tantalum (Ta), tungsten (W), nickel (Ni), cobalt (Co), or platinum (Pt). The conductive metal nitride may include at least one of titanium nitride (TiN), tantalum nitride (TaN), tungsten nitride (WN), nickel nitride (NiN), cobalt nitride (CoN), or platinum nitride (PtN).

According to some embodiments, the gate contact pattern CB may be positioned on at least one of the main gate structures MG_M and GI_M on the first region R1 of the substrate 110. According to some embodiments, the gate contact pattern CB may not be positioned on the dummy main gate structures DMG_M and DGI_M on the second region R2 of the substrate 110.

According to some embodiments, the gate contact pattern CB may be connected to at least one of the main gate electrodes MG_M through the second interlayer insulating layer 130, the third interlayer insulating layer 140 and the fourth interlayer insulating layer 150.

According to some embodiments, the gate contact pattern CB may electrically connect at least some of the upper wires FM1 to FM15 positioned in the upper wire region FS described below and at least one of the main gate electrodes MG_M. For example, the gate contact pattern CB may include aluminum, copper, tungsten, molybdenum, cobalt, or a combination thereof.

The semiconductor device according to some embodiments may further include the upper wire region FS positioned above the fourth interlayer insulating layer 150.

According to some embodiments, upper wires FM1 to FM15, upper vias and an upper insulation layer 310 may be positioned in the upper wire region FS. The upper wires FM1 to FM15 and the upper vias may include a metal (in some embodiments, copper).

The semiconductor device according to some embodiments may include a first dummy wiring 210 extending from at least one of upper wires FM1 to FM15 and positioned on the second region R2. For example, the first dummy wiring 210 may extend from the fifth upper wire FM5 and may be positioned on the second region R2. Unlike the diagram, a plurality of first dummy wiring 210 may be positioned on the second region R2, and for example, some of the plurality of first dummy wiring 210 may be positioned in the same layer as the fifth upper wire FM5, and other some may be positioned in a different layer from the fifth upper wire FM5.

According to some embodiments, the first dummy wiring 210 may extend from at least one of the upper wires FM1 to FM15 and protrude to or extend into the second region R2. In other words, the end point or portion of the first dummy wiring 210 may be positioned within or on the second region R2.

According to some embodiments, the first dummy wiring 210 may be integrally formed with at least one of the upper wires FM1 to FM15. In other words, the boundary between the first dummy wiring 210 and the upper wire connected to the first dummy wiring 210 may not be recognized or distinguishable.

According to some embodiments, one side of the first dummy wiring 210 may be connected to at least one of the upper wires FM1 to FM15, and the other side of the first dummy wiring 210 may be positioned within or on the second region R2. Accordingly, the other side of the first dummy wiring 210 may be at least partially surrounded by the upper insulation layer 310 and may not be connected to other conductive layers. The end point or portion of the wiring connected to the first dummy wiring 210 and not connected to the first dummy wiring 210 may be positioned within or on the first region R1.

The upper insulation layer 310 may be placed between the upper wires FM1 to FM15 and the upper vias to insulate them. The upper insulation layer 310 may cover the fourth interlayer insulating layer 150. The upper wires FM1 to FM15 and upper vias may be positioned within the upper insulation layer 310.

According to some embodiments the upper insulation layer 310 may include at least one of silicon oxide (SiOx), silicon nitride (SiNx), silicon oxynitride (SiON), or low dielectric layers.

According to some embodiments, at least a portion of the upper wires FM1 to FM15 may be electrically connected to the main gate electrode MG_M and at least one of the source/drain patterns SD. According to some embodiments, the upper wires FM1 to FM15 may not be electrically connected to the dummy main gate electrode DMG_M and the dummy source/drain patterns DSD. In other words, the dummy main gate electrode DMG_M and the dummy source/drain patterns DSD may be electrically isolated from the upper wires FM1 to FM15.

According to some embodiments, an electrical signal or a power voltage supplied from the outside (e.g. from an external device or circuit) may be provided to the source/drain pattern SD through the upper wires FM1 to FM15 and the contact pattern CA connected thereto. According to some embodiments, an electrical signal or a power voltage supplied from the outside may be provided to the main gate electrode MG_M through upper wires FM1 to FM15 and gate contact pattern CB connected thereto. According to some embodiments, an electrical signal or a power voltage supplied from the outside may not be provided to the dummy source/drain pattern DSD and the dummy main gate electrode DMG_M.

The semiconductor device according to some embodiments may further include a lower contact pattern BCA positioned below at least one of the source/drain patterns SD and a lower wire region BS positioned on the lower surface of the substrate 110.

According to some embodiments, the lower contact pattern BCA may penetrate or extend into the substrate 110 and be electrically connected to at least one of the source/drain patterns SD on the first region R1. According to some embodiments, the lower contact pattern BCA may not be electrically connected to the dummy source/drain patterns DSD on the second region R2.

According to some embodiments, the lower contact pattern BCA may be positioned adjacent to the sub-gate electrode MG_S in the first direction D1. According to some embodiments, the lower contact pattern BCA may electrically connect at least some of the lower wires BM1 to BM8 to at least one of the source/drain patterns SD. According to some embodiments, the lower contact pattern BCA may not electrically connect at least some of the lower wires BM1, BM2, BM3, BM4, BM5, BM6, BM7, and BM8 to the dummy source/drain patterns DSD.

According to some embodiments the lower contact pattern BCA may include at least one of a metal, a metal alloy, a conductive metal nitride, a conductive metal carbide, a conductive metal oxide, a conductive metal carbon nitride, or a two-dimensional material (two-dimensional 2D material). The metal may include at least one of titanium (Ti), tantalum (Ta), tungsten (W), nickel (Ni), cobalt (Co), or platinum (Pt). The conductive metal nitride may include at least one of titanium nitride (TiN), tantalum nitride (TaN), tungsten nitride (WN), nickel nitride (NiN), cobalt nitride (CoN), or platinum nitride (PtN).

According to some embodiments, lower wires BM1 to BM8, lower vias and a lower insulation layer 320 may be positioned in the lower wire region BS. The lower wires BM1 to BM8 and the lower vias may include a metal (in some embodiments, copper).

The semiconductor device according to some embodiments may include a second dummy wiring 220 extending from at least one of the lower wires BM1 to BM8 and positioned on the second region R2. For example, the second dummy wiring 220 may extend from the third lower wire BM3 and be positioned on the second region R2. Unlike what is shown, the second dummy wiring 220 may be connected to any of the lower wires BM1 to BM8, and may also be connected to the plurality of wirings.

According to some embodiments, the second dummy wiring 220 may extend from at least one of the lower wires BM1 to BM8 and protrude or extend into the second region R2. In other words, the end point or portion of the second dummy wiring 220 may be positioned within or on the second region R2.

According to some embodiments, the second dummy wiring 220 may be integrally formed with at least one of the lower wires BM1 to BM8. In other words, the boundary between the second dummy wiring 220 and the lower wire connected to the second dummy wiring 220 may not be recognized or distinguishable.

According to some embodiments, one side of the second dummy wiring 220 may be connected to at least one of the lower wires BM1 to BM8, and the other side of the second dummy wiring 220 may be positioned within or on the second region R2. Accordingly, the other side of the second dummy wiring 220 may be at least partially surrounded by the lower insulation layer 320 and may not be connected to any other conductive layer. The end of the wiring connected to the second dummy wiring 220 and not connected to the second dummy wiring 220 may be positioned within or on the first region R1.

According to some embodiments, the lower insulation layer 320 may be placed between the lower wires BM1 to BM8 and the lower vias to insulate them. The lower insulation layer 320 may cover or at least partially overlap the substrate 110. The lower wires BM1 to BM8 and the lower vias may be positioned within the lower insulation layer 320.

According to some embodiments the lower insulation layer 320 may include at least one of silicon oxide (SiOx), silicon nitride (SiNx), silicon oxynitride (SiON), or low dielectric layers.

According to some embodiments, at least some of the lower wires BM1 to BM8 may be electrically connected to at least one of the source/drain patterns SD. According to some embodiments, the lower wires BM1 to BM8 may not be electrically connected to the dummy source/drain patterns DSD. In other words, the dummy source/drain patterns DSD may be isolated from the lower wires BM1 to BM8.

According to some embodiments, an electrical signal or a power voltage supplied from the outside may be provided to the source/drain pattern SD through the lower wires BM1 to BM8 and the lower contact pattern BCA connected thereto.

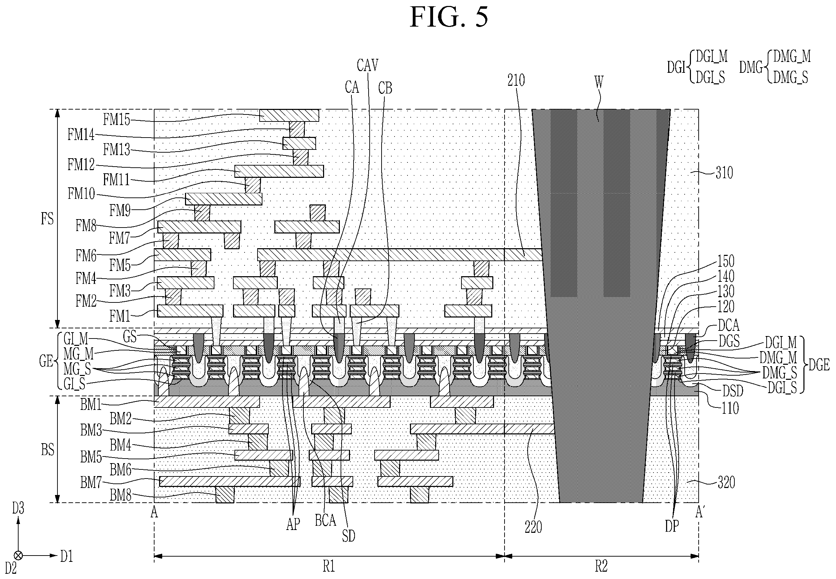

FIG. 5 to FIG. 7 are cross-sectional views illustrating a method for performing a failure analysis according to some embodiments.

Referring to FIG. 5, a semiconductor device that is a subject of a failure analysis according to some embodiments may be provided. As a method of the failure analysis, a method that electrically connects a source (Source), a drain (Drain), and a gate (Gate) of the semiconductor device by using a tungsten pad W and then performs a layer removal process (a delayering) may be used.

Below, the method for analyzing defects in the semiconductor device according to the present disclosure through the layer removal process (the delayering) is specifically described.

According to some embodiments, the tungsten pad W may be formed on the second region R2 of the substrate 110. According to some embodiments, the tungsten pad W may be formed to penetrate or extend from the upper part of the upper insulation layer 310 to the lower part of the lower insulation layer 320. However, the formation position of the tungsten pad W is not limited to this and may be changed in various ways as needed. The tungsten pad W may be made of a highly conductive metal (e.g. tungsten) and can provide a stable electrical connection even after the layer removal process (the delayering). Whilst the tungsten pad W is described as being formed of tungsten, it may be formed of other materials (e.g. other metals). More generally, a conductive pad W is formed that extends from the upper part of the upper insulation layer 310 to the lower part of the lower insulation layer 320.

According to some embodiments, the tungsten pad W may be connected to the first dummy wiring 210 extending from at least one of the upper wires FM1 to FM15 and positioned on the second region R2 and the second dummy wiring 220 extending from at least one of the lower wires BM1 to BM8 and positioned on the second region R2. Unlike what is shown in FIG. 5, the tungsten pad W may be connected to one (e.g. only one) of the first dummy wiring 210 or the second dummy wiring 220. That is, the tungsten pad W may be connected to one or more of the upper wires FM1 to FM15 and lower wires BM1 to BM8.

According to some embodiments, the electrical characteristics of the semiconductor device may be initially measured while the tungsten pad W is connected to the first dummy wiring 210 and/or the second dummy wiring 220. The electrical characteristics of the semiconductor device may be initially measured by connecting it to an external test device through a probe or a wire bonding for electrical connection to the tungsten pad W.

According to some embodiments, the initial measurement target may include a current flow between a source and a drain, a gate leakage current, and a resistance value between each electrode. For example, by measuring a drain current, it may be determined whether there is a short circuit or a leak. For example, the gate leakage current may be measured to detect an insulation defect. For example, each resistance value may be measured between electrodes to check for a defective bonding.

Next, layers may be sequentially removed from the upper layer of the device by using chemical etching or mechanical polishing methods. After each layer removal, the electrical signal of the device is repeatedly measured through the tungsten pad W. It may be determined whether an electrical anomaly has occurred in a specific layer.

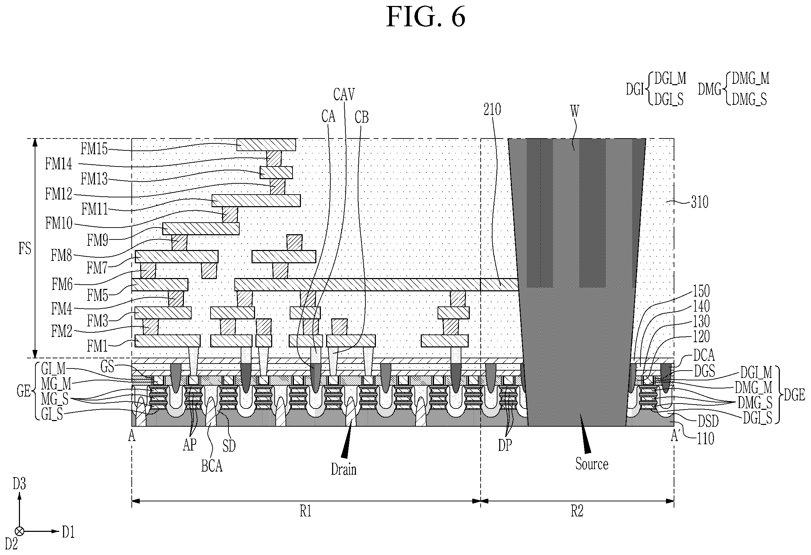

Referring to FIG. 6, when the tungsten pad W is connected to the first dummy wiring 210, the layer removal process in the lower wire region BS may be used.

Although not explicitly shown in FIG. 6, the first dummy wiring 210 may extend from the upper wire connected to the source/drain pattern SD and/or the main gate electrode MG_M. Accordingly, the tungsten pad W may be connected to the first dummy wiring 210, which is connected to the source/drain pattern SD. In some embodiments, the tungsten pad W may be connected to the first dummy wiring 210, which is connected to the main gate electrode MG_M. In some embodiments, the tungsten pad W may be connected to the first dummy wiring 210 which is connected to the source/drain pattern SD and the first dummy wiring 210 which is connected to the main gate electrode MG_M. In other words, the tungsten pad W may be connected to the first dummy wiring 210 connected to the source/drain pattern SD and the first dummy wiring 210 connected to the main gate electrode MG_M, respectively or together (or simultaneously).

Additionally, although not explicitly shown in FIG. 6, the semiconductor device according to some embodiments may include a lower gate contact pattern (not shown) connected to the sub-gate electrode MG_S. Accordingly, when the tungsten pad W is connected to the first dummy wiring 210, the electrical characteristics of the semiconductor device may be maintained because the source, the drain, and the gate are connected even if the layers are sequentially removed from the lower part of the lower wire region BS.

As described above, as the semiconductor device according to some embodiments of the present disclosure includes the first dummy wiring 210 extending from at least one of the upper wires FM1 to FM15 and positioned within the keep out zone (e.g., the second region R2 of FIG. 3), even if the layers are sequentially removed from the lower wire region BS, the defect analysis through the layer removal process (the delayering) may be facilitated by connecting the source, the drain, and the gate through the tungsten pad W.

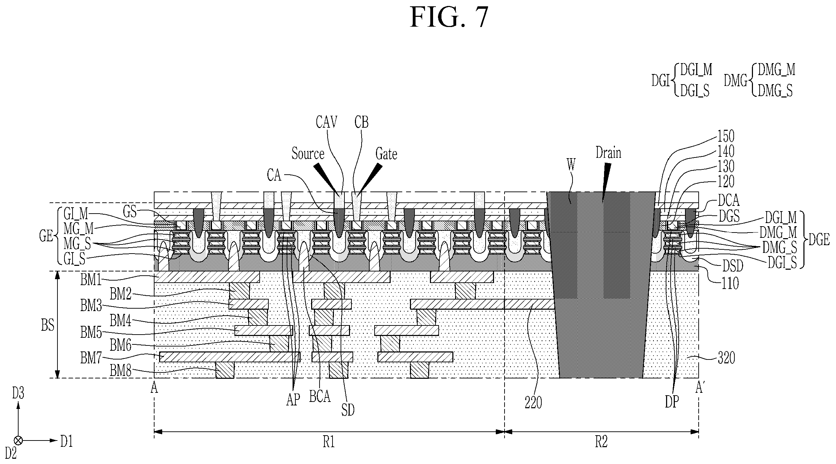

Referring to FIG. 7, when the tungsten pad W is connected to the second dummy wiring 220, the layer removal process in the upper wire region FS may be utilized.

According to some embodiments, when the tungsten pad W is connected to the second dummy wiring 220, the electrical characteristics of the semiconductor device may be maintained because the source, the drain, and the gate are connected even if the layers are sequentially removed from the upper part of the upper wire region FS.

As described above, as the semiconductor device according to some embodiments of the present disclosure includes the second dummy wiring 220 extending from at least one of the lower wires BM1 to BM8 and positioned within the keep out zone (e.g., the second region R2 of FIG. 3), even if the layers are sequentially removed from the upper part of the upper wire region FS, the defect analysis through the layer removal process (the delayering) may be facilitated by connecting the source, the drain, and the gate through the tungsten pad W.

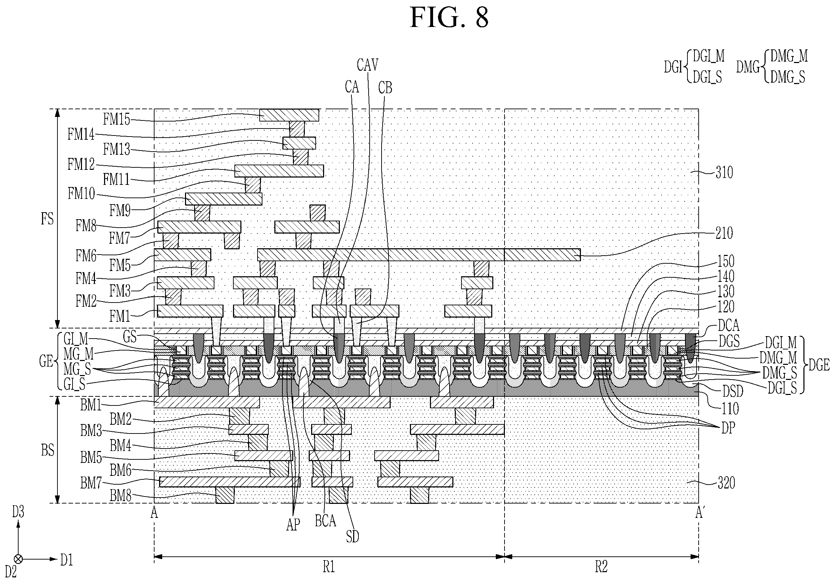

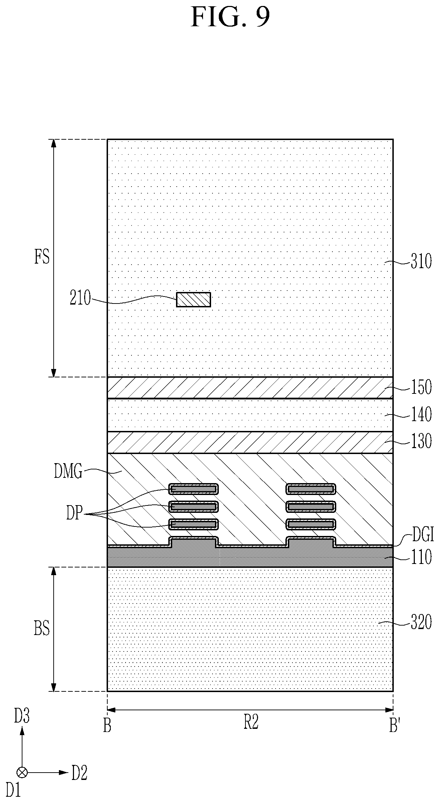

FIG. 8 is a cross-sectional view taken along a line A-A' of FIG. 2 according to some embodiments. FIG. 9 is a cross-sectional view taken along line B-B' of FIG. 2 according to some embodiments.

The semiconductor devices illustrated in FIG. 8 and FIG. 9 may include components similar to or identical to the semiconductor devices described with reference to FIG. 1 to FIG. 7. However, the semiconductor device in the present embodiment has a structure that includes a first dummy wiring 210 connected to at least one of the upper wires FM1 to FM15, and does not include a dummy wiring (e.g., the second dummy wiring 220 of FIG. 3) connected to at least one of the lower wires BM1 to BM8, unlike those illustrated in FIG. 1 to FIG. 7. Here, any overlapping content from the above will be briefly explained or omitted, and the differences will be explained primarily.

The semiconductor device according to some embodiments may include a first dummy wiring 210 extending from at least one of the upper wires FM1 to FM15 and positioned on the second region R2. For example, the first dummy wiring 210 may extend from the fifth upper wire FM5 and positioned on the second region R2. Unlike as shown in the diagram, a plurality of first dummy wirings 210 may be positioned on the second region R2, and for example, some of the plurality of first dummy wirings 210 may be positioned in the same layer as the fifth upper wire FM5, and others may be positioned in a different layer from the fifth upper wire FM5.

According to some embodiments, the first dummy wiring 210 may extend from at least one of the upper wires FM1 to FM15 and protrude to or extend into the second region R2. In other words, the end point or portion of the first dummy wiring 210 may be positioned within or on the second region R2.

According to some embodiments, the first dummy wiring 210 may be integrally formed with at least one of the upper wires FM1 to FM15. In other words, the boundary between the first dummy wiring 210 and the upper wire connected to the first dummy wiring 210 may not be recognized or distinguishable.

According to some embodiments, one side of the first dummy wiring 210 may be connected to at least one of the upper wires FM1 to FM15, and the other side of the first dummy wiring 210 may be positioned within or on the second region R2. Accordingly, the other side of the first dummy wiring 210 may be at least partially surrounded by the upper insulation layer 310 and may not be connected to other conductive layers. The end of the wiring connected to the first dummy wiring 210 and not connected to the first dummy wiring 210 may be positioned within or on the first region R1.

According to some embodiments, the first dummy wiring 210 may be connected to the upper wire positioned at the shortest distance along the first direction D1 from the second region R2 among the upper wires FM1 to FM15. For example, the first dummy wiring 210 may be connected to the fifth upper wire FM5 which is positioned at the shortest end from the second region R2 among the upper wires FM1 to FM15.

As described above, the semiconductor device according to some embodiments of the present disclosure includes a first dummy wiring 210 connected to the upper wire positioned at the shortest distance along the first direction D1 from the second region R2 among the upper wires FM1 to FM15, thereby minimizing the length of the first dummy wiring 210. Accordingly, the performance degradation of the semiconductor device due to the first dummy wiring 210 may be minimized or inhibited.

According to some embodiments, although not explicitly shown, the first dummy wiring 210 may be connected to the upper wire connected to the most source/drain patterns SD and/or main gate electrodes MG_M among the upper wires FM1 to FM15 (e.g., the first dummy wiring 210 is electrically connected to a majority (e.g., more than half) of the source/drain patterns SD and/or main gate electrodes MG_M).

As described above, the semiconductor device according to some embodiments of the present disclosure may include the first dummy wiring 210 connected to the upper wire connected to a largest number of the source/drain patterns SD and/or main gate electrodes MG_M among the upper wires FM1 to FM15, thereby improving an accuracy of the analysis in the defect analysis using the layer removal process (the delayering).

The semiconductor device according to some embodiments may not include a dummy wiring (e.g., the second dummy wiring 220 of FIG. 3) extending from at least one of the lower wires BM1 to BM8 and positioned on the second region R2.

According to some embodiments, the ends of the lower wires BM1 to BM8 may not be positioned within or on the second region R2. In other words, the lower wires BM1 to BM8 may not protrude to or extend into the second region R2.

In some embodiments, when the semiconductor device includes the first dummy wiring 210 and does not include the dummy wiring extending from at least one of the lower wires BM1 to BM8 and positioned on the second region R2, referring to FIG. 6, as described above, a layer removal process (a delayering) that sequentially removes layers from the lower part of the lower wire region BS may be used.

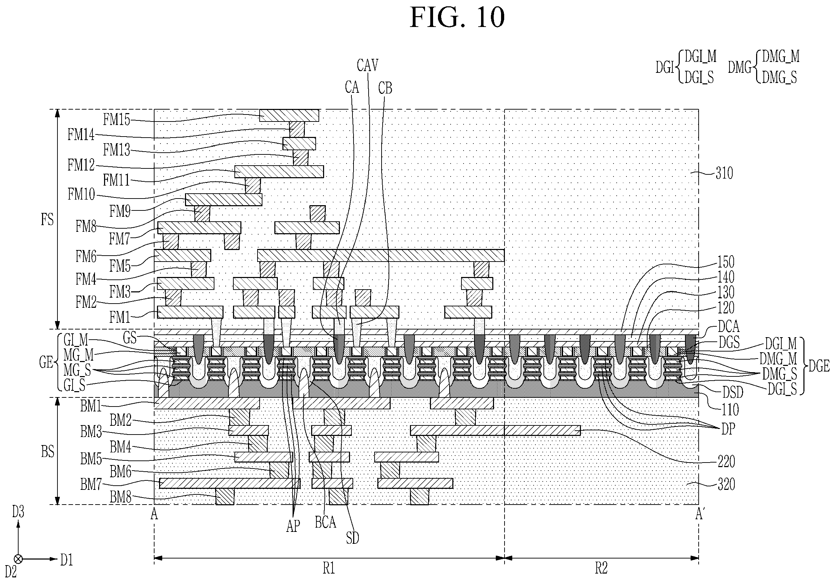

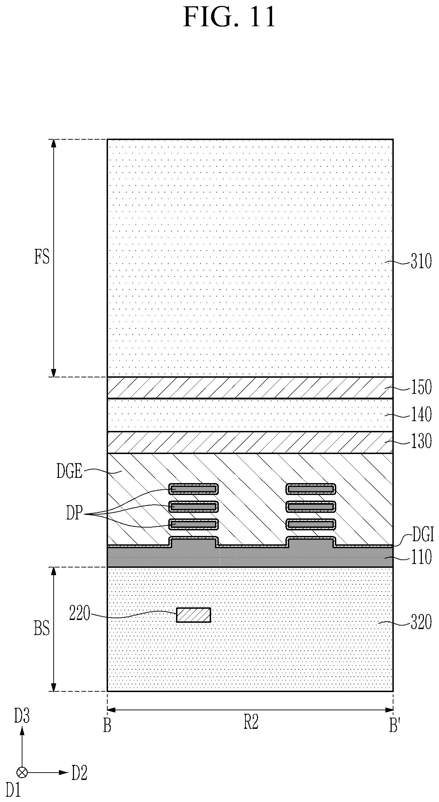

FIG. 10 is a cross-sectional view taken along a line A-A' of FIG. 2 according to some embodiments. FIG. 11 is a cross-sectional view taken along a line B-B' of FIG. 2 according to some embodiments.

The semiconductor devices illustrated in FIG. 10 and FIG. 11 may include components similar to or identical to the semiconductor devices described with reference to FIG. 1 to FIG. 7. However, the semiconductor device in the present embodiment has a structure that includes a second dummy wiring 220 connected to at least one of the lower wires BM1 to BM8, and does not include a dummy wiring (e.g., the first dummy wiring 210 of FIG. 3) connected to at least one of the upper wires FM1 to FM15, unlike those illustrated in FIG. 1 to FIG. 7,

Here, any overlapping content from the above will be briefly explained or omitted, and the differences will be explained primarily.

The semiconductor device according to some embodiments may include a second dummy wiring 220 extending from at least one of the lower wires BM1 to BM8 and positioned on the second region R2. For example, the second dummy wiring 220 may extend from the third lower wire BM3 and be positioned on the second region R2. As shown, the second dummy wiring 220 may be connected to any of the lower wires BM1 to BM8, and may also be connected to a plurality of wirings.

According to some embodiments, the second dummy wiring 220 may extend from at least one of the lower wires BM1 to BM8 and protrude or extend into the second region R2. In other words, the end point or portion of the second dummy wiring 220 may be positioned within or on the second region R2.

According to some embodiments, the second dummy wiring 220 may be integrally formed with at least one of the lower wires BM1 to BM8. In other words, the boundary between the second dummy wiring 220 and the lower wire connected to the second dummy wiring 220 may not be recognized or distinguishable.

According to some embodiments, one side of the second dummy wiring 220 can be connected to at least one of the lower wires BM1 to BM8, and the other side of the second dummy wiring 220 may be positioned within or on the second region R2. Accordingly, the other side of the second dummy wiring 220 may be at least partially surrounded by the lower insulation layer 320 and may not be connected to any other conductive layer. The end of the wiring connected to the second dummy wiring 220 and not connected to the second dummy wiring 220 may be positioned within or on the first region R1.

According to some embodiments, the second dummy wiring 220 may be connected to the lower wire positioned at the shortest distance along the first direction D1 from the second region R2 among the lower wires BM1 to BM8. For example, the second dummy wiring 220 may be connected to the third lower wire BM3, which has the end positioned at the shortest distance from the second region R2 among the lower wires BM1 to BM8.

As described above, the semiconductor device according to some embodiments of the present disclosure may minimize or reduce the length of the second dummy wiring 220 by connecting it to the lower wire positioned at the shortest distance along the first direction D1 from the second region R2 among lower wires BM1 to BM8. Accordingly, the performance degradation of the semiconductor device due to the second dummy wiring 220 may be minimized or inhibited.

According to some embodiments, although not explicitly shown, the second dummy wiring 220 may be connected to the lower wire connected to the most source/drain patterns SD among the lower wires BM1 to BM8 (e.g., the second dummy wiring 220 is electrically connected to a majority of the source/drain patterns SD).

As described above, the semiconductor device according to some embodiments of the present disclosure includes the second dummy wiring 220 connected to the lower wire connected to a largest number of the source/drain patterns SD among the lower wires BM1 to BM8, thereby improving the accuracy of the analysis during the defect analysis using the layer removal process (the delayering).

The semiconductor device according to some embodiments may not include a dummy wiring (e.g., the first dummy wiring 210 of FIG. 3) extending from at least one of upper wires FM1 to FM15 and positioned on the second region R2.

According to some embodiments, the ends of the upper wires FM1 to FM15 may not be positioned within or on the second region R2. In other words, the upper wires FM1 to FM15 may not protrude to or extend into the second region R2.

When the semiconductor device according to some embodiments includes the second dummy wiring 220 and does not include a dummy wiring extending from at least one of the upper wires FM1 to FM15 and positioned on the second region R2, a layer removal process (a delayering) that sequentially removes the layers from the upper part of the upper wire region FS, as described above with reference to FIG. 7, may be utilized.

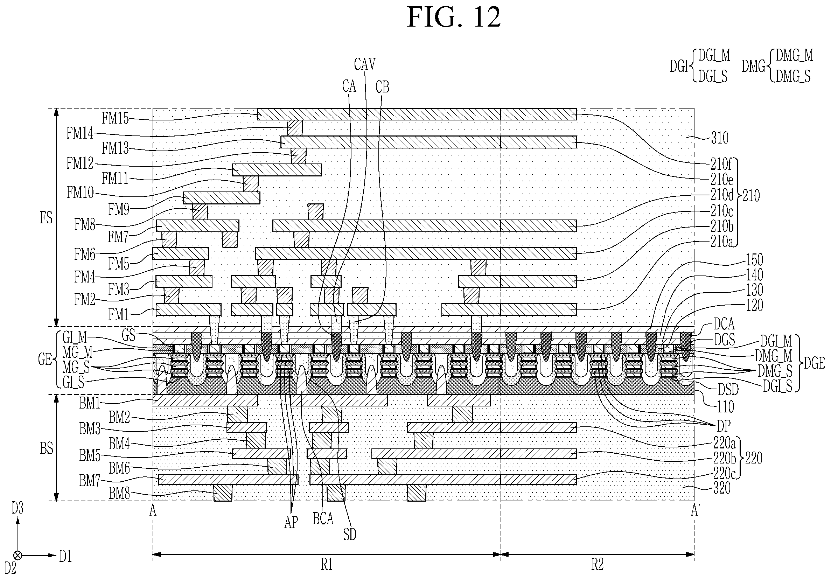

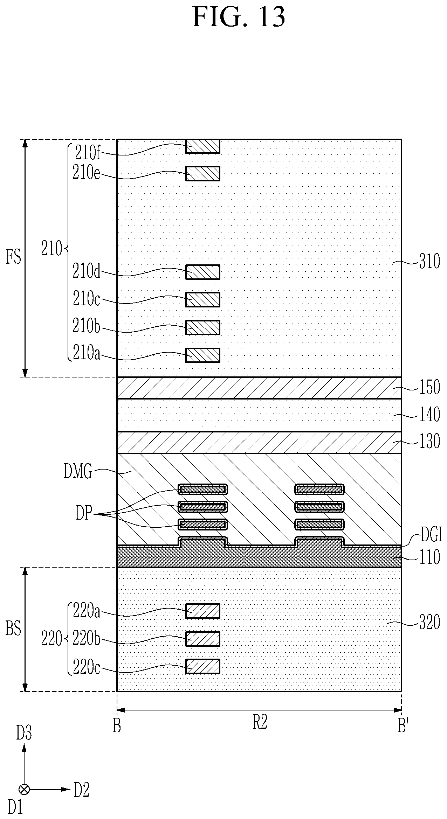

FIG. 12 is a cross-sectional view taken along a line A-A' of FIG. 2 according to some embodiments. FIG. 13 is a cross-sectional view taken along a line B-B' of FIG. 2 according to some embodiments.

The semiconductor devices illustrated in FIG. 12 and FIG. 13 may include components similar to or identical to the semiconductor devices described with reference to FIG. 1 to FIG. 7. However, the semiconductor device in the present embodiment has a structure that includes first dummy wirings 210 connected to the plurality of wirings among upper wires FM1 to FM15, and second dummy wirings 220 connected to a plurality of wirings among lower wires BM1 to BM8, unlike those illustrated in FIG. 1 to FIG. 7. Here, any overlapping content from the above will be briefly explained or omitted, and the differences will be explained primarily.

The semiconductor device according to some embodiments may include first dummy wirings 210 extending from the plurality of wirings among upper wires FM1 to FM15 and positioned on the second region R2. According to some embodiments, the first dummy wirings 210 may include eleventh to sixteenth dummy wirings 210a, 210b, 210c, 210d, 210e, and 210f. For example, the eleventh to sixteenth dummy wirings 210a, 210b, 210c, 210d, 210e, and 210f may be positioned on the second region R2 by extending from the first upper wire FM1, the third upper wire FM3, the fifth upper wire FM5, the seventh upper wire FM7, the thirteenth upper wire FM13, and the fifteenth upper wire FM15, respectively. However, what is shown in FIG. 12 and FIG. 13 is not limited thereto, and the connection relationship of the first dummy wiring 210 may be changed in various ways.

According to some embodiments, the eleventh to sixteenth dummy wirings 210a, 210b, 210c, 210d, 210e, and 210f may extend from the first upper wire FM1, the third upper wire FM3, the fifth upper wire FM5, the seventh upper wire FM7, the thirteenth upper wire FM13 and the fifteenth upper wire FM15, respectively, and protrude to or extend into the second region R2. In other words, the end points or portions of the eleventh to sixteenth dummy wirings 210a, 210b, 210c, 210d, 210e, and 210f may be positioned within or on the second region R2.

According to some embodiments, the eleventh to sixteenth dummy wirings 210a, 210b, 210c, 210d, 210e, and 210f may be integrally formed with the first upper wire FM1, the third upper wire FM3, the fifth upper wire FM5, the seventh upper wire FM7, the thirteenth upper wire FM13 and the fifteenth upper wire FM15, respectively.

According to some embodiments, first sides of the eleventh to sixteenth dummy wirings 210a, 210b, 210c, 210d, 210e, and 210f may be respectively connected to the first upper wire FM1, the third upper wire FM3, the fifth upper wire FM5, the seventh upper wire FM7, the thirteenth upper wire FM13, and the fifteenth upper wire FM15, and second sides of the eleventh to sixteenth dummy wirings 210a, 210b, 210c, 210d, 210e, and 210f may be positioned within or on the second region R2.

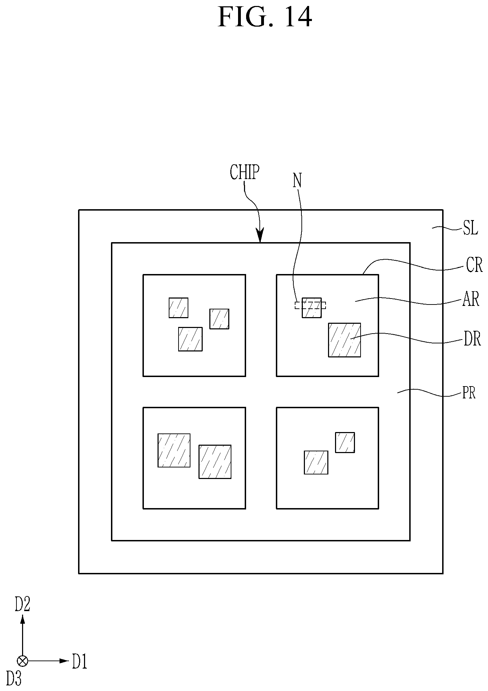

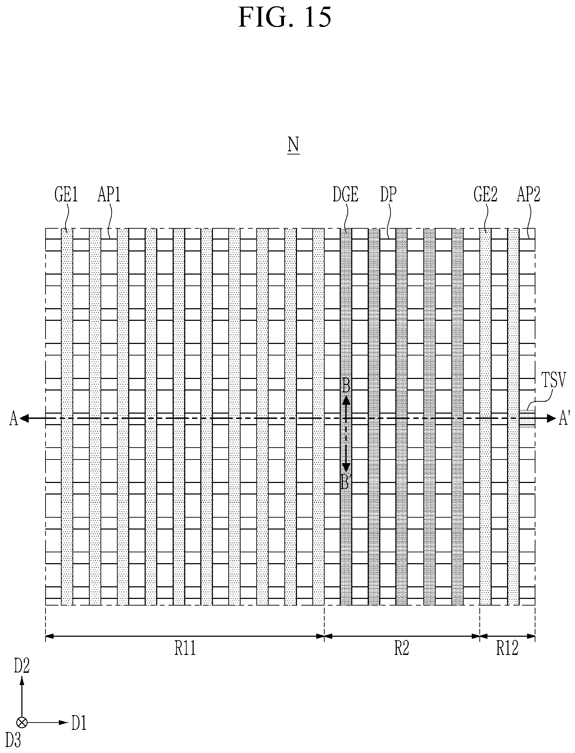

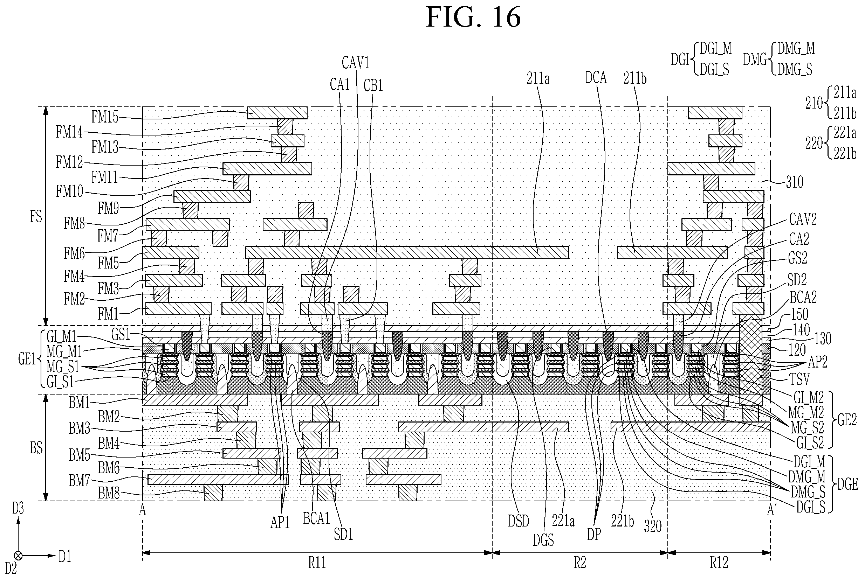

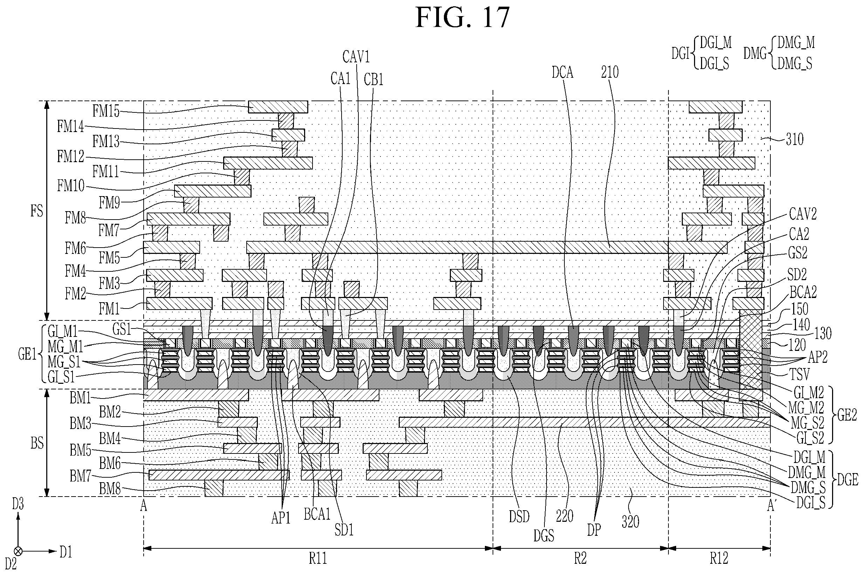

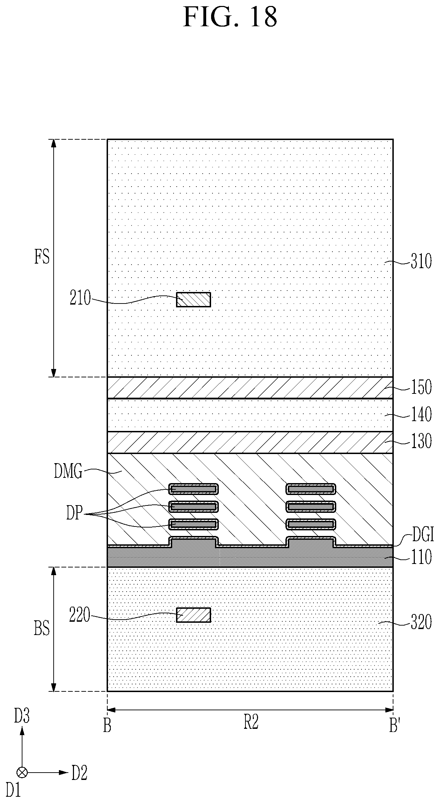

FIG. 14 is a top plan view showing a semiconductor device according to some embodiments. FIG. 15 is an enlarged view of a region N of FIG. 14 according to some embodiments. FIG. 16 is a cross-sectional view taken along a line A-A' of FIG. 15 according to some embodiments. FIG. 17 is a cross-sectional view taken along a line A-A' of FIG. 15 according to some embodiments. FIG. 18 is a cross-sectional view taken along a line B-B' of FIG. 15 according to some embodiments.

The semiconductor devices illustrated in FIG. 14 to FIG. 18 may include components similar to or identical to the semiconductor devices described with reference to FIG. 1 to FIG. 13. However, the semiconductor device in the present embodiments is different from that illustrated in FIG. 1 to FIG. 13 in that it has a structure in which a keep-out zone is positioned within or between a plurality of cell regions of the substrate. Here, any overlapping content from the above will be briefly explained or omitted, and the differences will be explained primarily.

Referring to FIG. 14, the semiconductor wafer may include semiconductor chip regions CHIP and scribe lane regions SL between the semiconductor chip regions CHIP. Additionally, the semiconductor chip region CHIP may include a cell region CR and a peripheral region PR. Specific descriptions related to each region are given with reference to FIG. 1 above, so they are simplified or omitted.

According to some embodiments, the semiconductor chip region CHIP may include a plurality of cell regions CR. According to some embodiments, each of the plurality of cell regions CR may include an element region AR in which an activation pattern AP, gate electrodes MG_M1, MG_S1, MG_M2, and MG_S2 and source/drain patterns SD1 and SD2 are positioned, and a dummy region DR in which a dummy pattern DP, dummy gate electrodes DMG_M and DMG_S and a dummy source/drain pattern DSD are positioned.

Referring to FIG. 15 to FIG. 17, a substrate 110 including an eleventh region R11, a twelfth region R12 and a second region R2 may be provided. According to some embodiments, the eleventh region R11 and the twelfth region R12 may be any region among the element regions AR of FIG. 14, and the second region R2 may be any region among the dummy regions DR of FIG. 14. In the present disclosure, for better comprehension and ease of description, the eleventh region R11 and the twelfth region R12 are depicted and described separately, but the eleventh region R11 and the twelfth region R12 are arbitrary regions among the element regions AR, and their boundaries may not be clearly distinguished. In the present disclosure, the eleventh region R11 and the twelfth region R12 may correspond to regions including electrically active transistors, and the second region R2 may correspond to a region including electrically inactive transistors.

In the present disclosure, the second region R2 may be referred to as a keep out zone. The keep-out zone may mean a region designed so that a wiring is not intentionally connected to a transistor.

According to some embodiments, the eleventh region R11 and the twelfth region R12 may be positioned on both sides of the second region R2. According to some embodiments, dummy gate structures DGE described later on the second region R2 may be arranged sequentially and spaced apart from each other in the first direction D1. Accordingly, the dummy gate structures DGE may be positioned on both edges of the second region R2.

According to some embodiments, the semiconductor device may include, in an eleventh region R11, a first activation pattern AP1 spaced apart along the first direction D1 on the first surface of the substrate 110, first source/drain patterns SD1 connected to both sides of the first activation pattern AP1, and a first gate structure GE1 surrounding or extending around the first activation pattern AP1 and extending in the second direction D2. According to some embodiments, the first gate structure GE1 may include a plurality of first sub-gate structures MG_S1 and GI_S1 and a first main gate structure MG_M1 and GI_M1. According to some embodiments, the first sub-gate structure MG_S1 and GI_S1 may include a first sub-gate electrode MG_S1 and a first sub-gate insulation layer GI_S1. According to some embodiments, the first main gate structure MG_M1 and GI_M1 may include a first main gate electrode MG_M1 and a first main gate insulation layer GI_M1.

According to some embodiments, the semiconductor device may include, in or on the twelfth region R12, a second activation pattern AP2 spaced apart along the first direction D1 on the first surface of the substrate 110, second source/drain patterns SD2 connected to both sides of the second activation pattern AP2, and a second gate structure GE2 extending in the second direction D2 while surrounding or extending around the second activation pattern AP2. According to some embodiments, the second gate structure GE2 may include a plurality of second sub-gate structures MG_S2 and GI_S2 and a second main gate structure MG_M2 and GI_M2. According to some embodiments, the second sub-gate structure MG_S2 and GI_S2 may include a second sub-gate electrode MG_S2 and a second sub-gate insulation layer GI_S2. According to some embodiments, the second main gate structure MG_M2 and GI_M2 may include a second main gate electrode MG_M2 and a second main gate insulation layer GI_M2.

According to some embodiments, the semiconductor device may further include a through-hole via (e.g. a through-silicon via) TSV positioned in or on the twelfth region R12. According to some embodiments, the through-hole via TSV may extend in the third direction D3 and electrically connect the lower wires BM1 to BM8 to the upper wires FM1 to FM15. The number and arrangement of the through-hole via TSV may vary.

According to some embodiments, the semiconductor device may include, in or on the second region R2, a dummy pattern DP spaced apart along the first direction D1 on the first surface of the substrate 110, dummy source/drain patterns DSD connected to both sides of the dummy pattern DP, and a dummy gate structure DGE surrounding or extending around the dummy pattern DP and extending in the second direction D2. According to some embodiments, the dummy gate structure DGE may include a plurality of dummy sub-gate structures DMG_S and DGI_S and a dummy main gate structure DMG_M and DGI_M. According to some embodiments, the dummy sub-gate structure DMG_S and DGI_S may include a dummy sub-gate electrode DMG_S and a dummy sub-gate insulation layer DGI_S. According to some embodiments, the dummy main gate structure DMG_M and DGI_M may include a dummy main gate electrode DMG_M and a dummy main gate insulation layer DGI_M.

The semiconductor device according to some embodiments may further include a first gate spacer GS1, a second gate spacer GS2, and a dummy gate spacer DGS in or on the eleventh region R11, the twelfth region R12, and the second region R2, respectively. According to some embodiments, the semiconductor device may further include a first interlayer insulating layer 120, a second interlayer insulating layer 130, a third interlayer insulating layer 140, and a fourth interlayer insulating layer 150. According to some embodiments, the semiconductor device may include a first contact pattern CA1, a first contact via CAV1, and a first gate contact pattern CB1 on the eleventh region R11, may include a second contact pattern CA2 and a second contact via CAV2 on the twelfth region R12, and further include a dummy contact pattern DCA on the second region R2. Although not shown, the semiconductor device according to some embodiments may further include a second gate contact pattern positioned on at least one of the second main gate structures MG_M2 and GI_M2 on the twelfth region R12.

Specific descriptions related to the above components are given in FIG. 2 to FIG. 13 above, and are therefore simplified or omitted. For example, the components positioned on the eleventh region R11 and the twelfth region R12 may correspond to the components on the first region R1 described above with reference to FIG. 2, to FIG. 13. Also, for example, the components positioned on the second region R2 may correspond to the components on the second region R2 described above with reference to FIG. 2 to FIG. 13.

The semiconductor device according to some embodiments with reference to FIG. 16 and FIG. 17 may further include an upper wire region FS positioned above the fourth interlayer insulating layer 150.

According to some embodiments, upper wires FM1 to FM15, upper vias and an upper insulation layer 310 may be positioned in the upper wire region FS.

Referring to FIG. 16, the semiconductor device according to some embodiments may include an eleventh dummy wiring 211a extending from at least one of the upper wires FM1 to FM15 on the eleventh region R11 and positioned on the second region R2. For example, the eleventh dummy wiring 211a may extend from the fifth upper wire FM5 on the eleventh region R11 and be positioned on the second region R2.

The semiconductor device according to some embodiments may include a twelfth dummy wiring 211b extending from at least one of upper wires FM1 to FM15 on the twelfth region R12 and positioned on the second region R2. For example, the twelfth dummy wiring 211b may extend from the fifth upper wire FM5 on the twelfth region R12 and be positioned on the second region R2.

According to some embodiments, the eleventh dummy wiring 211a and the twelfth dummy wiring 211b may extend from at least one of the upper wires FM1 to FM15 on the eleventh region R11 and the twelfth region R12, respectively, and protrude to or extend into the second region R2. In other words, the end points of the eleventh dummy wiring 211a and the twelfth dummy wiring 211b may be positioned within or on the second region R2.

According to some embodiments, the eleventh dummy wiring 211a and the twelfth dummy wiring 211b may be integrally formed with at least one of the upper wires FM1 to FM15 on the eleventh region R11 and the twelfth region R12, respectively. In other words, the boundary between the eleventh dummy wiring 211a and the wiring on the eleventh region R11 connected to the eleventh dummy wiring 211a may not be recognized or distinguishable. In other words, the boundary between the twelfth dummy wiring 211b and the wiring on the twelfth region R12 connected to the twelfth dummy wiring 211b may not be recognized or distinguishable.

According to some embodiments, one side of each of the eleventh dummy wiring 211a and the twelfth dummy wiring 211b may be connected to at least one of the upper wires FM1 to FM15 on the eleventh region R11 and the twelfth region R12, and the other side of each of the eleventh dummy wiring 211a and the twelfth dummy wiring 211b may be positioned within or on the second region R2.

The semiconductor device according to some embodiments may further include a first lower contact pattern BCA1 positioned below at least one of the first source/drain patterns SD1, a second lower contact pattern BCA2 positioned below at least one of the second source/drain patterns SD2, and a lower wire region BS positioned on the lower surface of the substrate 110.

Specific descriptions related to the above components are given with reference to FIG. 2 to FIG. 13, above, and are therefore simplified or omitted. For example, the components positioned on the eleventh region R11 and the twelfth region R12 may correspond to the components on the first region R1 described with reference to FIG. 2 to FIG. 13. Also, for example, the components positioned on the second region R2 may correspond to the components on the second region R2 described above with reference to FIG. 2 to FIG. 13.

According to some embodiments, lower wires BM1 to BM8, lower vias and a lower insulation layer 320 may be positioned in the lower wire region BS.

Referring to FIG. 16, the semiconductor device according to some embodiments may include a twenty-first dummy wiring 221a extending from at least one of lower wires BM1 to BM8 on the eleventh region R11 and positioned on the second region R2. For example, the twenty-first dummy wiring 221a may extend from the third lower wire BM3 on the eleventh region R11 and be positioned on the second region R2.

The semiconductor device according to some embodiments may include a twenty-second dummy wiring 221b extending from at least one of the lower wires BM1 to BM8 on the twelfth region R12 and positioned on the second region R2. For example, the twenty-second dummy wiring 221b may extend from the third lower wire BM3 on the twelfth region R12 and be positioned on the second region R2.

According to some embodiments, the twenty-first dummy wiring 221a and the twenty-second dummy wiring 221b may extend from at least one of the lower wires BM1 to BM8 on the eleventh region R11 and the twelfth region R12, respectively, and protrude to or extend into the second region R2. In other words, the end point of each of the twenty-first dummy wiring 221a and the twenty-second dummy wiring 221b may be positioned within or on the second region R2.

According to some embodiments, the twenty-first dummy wiring 221a and the twenty-second dummy wiring 221b may be integrally formed with at least one of the lower wires BM1 to BM8 on the eleventh region R11 and the twelfth region R12, respectively. In other words, the boundary between the twenty-first dummy wiring 221a and the lower wire on the eleventh region R11 connected to the twenty-first dummy wiring 221a may not be recognized or distinguishable. In other words, the boundary between the twenty-second dummy wiring 221b and the lower wire on the twelfth region R12 connected to the twenty-second dummy wiring 221b may not be recognized or distinguishable.

According to some embodiments, one side of each of the twenty-first dummy wiring 221a and the twenty-second dummy wiring 221b may be connected to at least one of the lower wires BM1 to BM8 on the eleventh region R11 and the twelfth region R12, and the other side of each of the twenty-first dummy wiring 221a and the twenty-second dummy wiring 221b may be positioned within or on the second region R2.

Referring to FIG. 17, the semiconductor device according to some embodiments may include a first dummy wiring 210 and/or a second dummy wiring 220 extending across the second region R2 along the first direction D1 and connected to at least one of the first source/drain patterns SD1 and at least one of the second source/drain patterns SD2. Unlike the diagram, the first dummy wiring 210 may be connected to any wiring among the upper wires FM1 to FM15, and may also be connected to a plurality of wirings. Additionally, unlike what is shown, the second dummy wiring 220 may be connected to any of the lower wires BM1 to BM8, and may also be connected to a plurality of wirings.

According to some embodiments, the first dummy wiring 210 may extend from at least one of the upper wires FM1 to FM15 on the eleventh region R11 and connect to at least one of the upper wires FM1 to FM15 on the twelfth region R12 across the second region R2 along the first direction D1. For example, the first dummy wiring 210 may extend from the fifth upper wire FM5 on the eleventh region R11 and connect to the fifth upper wire FM5 on the twelfth region R12 across the second region R2 along the first direction D1.

According to some embodiments, the second dummy wiring 220 may extend from at least one of the lower wires BM1 to BM8 on the eleventh region R11 and be connected to at least one of the lower wires BM1 to BM8 on the twelfth region R12 across the second region R2 along the first direction D1. For example, the second dummy wiring 220 may extend from the third lower wire BM3 on the eleventh region R11 and be connected to the third lower wire BM3 on the twelfth region R12 across the second region R2 along the first direction D1.

According to some embodiments, the first dummy wiring 210 may be integrally formed with at least one of the upper wires FM1 to FM15. The boundary between the first dummy wiring 210 and the upper wire connected thereto may not be visible or distinguishable. For example, one side of the first dummy wiring 210 may be connected to the fifth upper wire FM5 on the eleventh region R11, and the other side of the first dummy wiring 210 may be connected to the fifth upper wire FM5 on the twelfth region R12.

According to some embodiments, the second dummy wiring 220 may be integrally formed with at least one of the lower wires BM1 to BM8. The boundary between the second dummy wiring 220 and the lower wire connected thereto may not be visible or distinguishable. For example, one side of the second dummy wiring 220 may be connected to the third lower wire BM3 on the eleventh region R11, and the other side of the second dummy wiring 220 may be connected to the third lower wire BM3 on the twelfth region R12.

Referring to FIG. 18, at least a portion of the dummy gate electrode DMG may be positioned on a structure in which the dummy sub-gate electrodes DMG_S and the dummy patterns DP are alternately stacked. Another part of the dummy gate electrode DMG may be formed to cover or at least partially overlap both sides of the structure in which the dummy sub-gate electrodes DMG_S and the dummy patterns DP are alternately stacked. Accordingly, four sides of the plurality of dummy patterns DP may be surrounded by the dummy gate electrode DMG. Although not shown, in the eleventh region R11, the four sides of the plurality of first activation pattern AP1s may be at least partially surrounded by the first gate electrode MG_M1, and in the twelfth region R12, the four sides of the plurality of second activation pattern AP2s may be surrounded by the second gate electrode MG_M2.

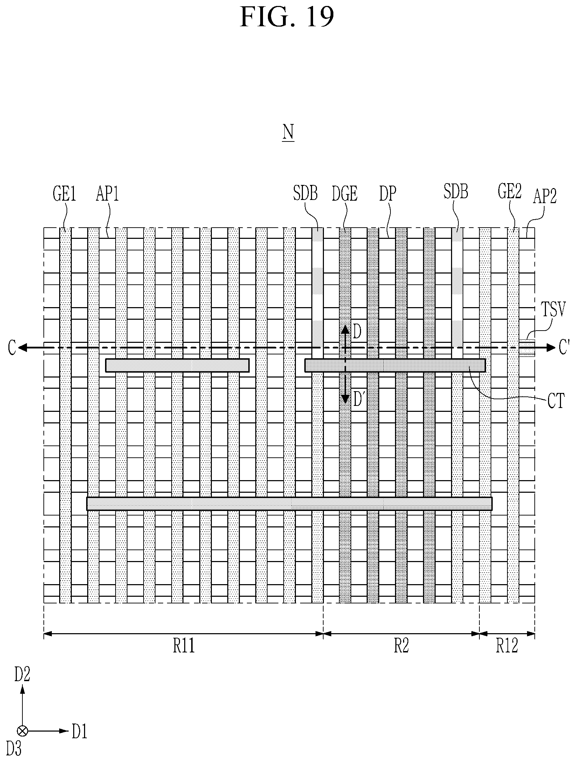

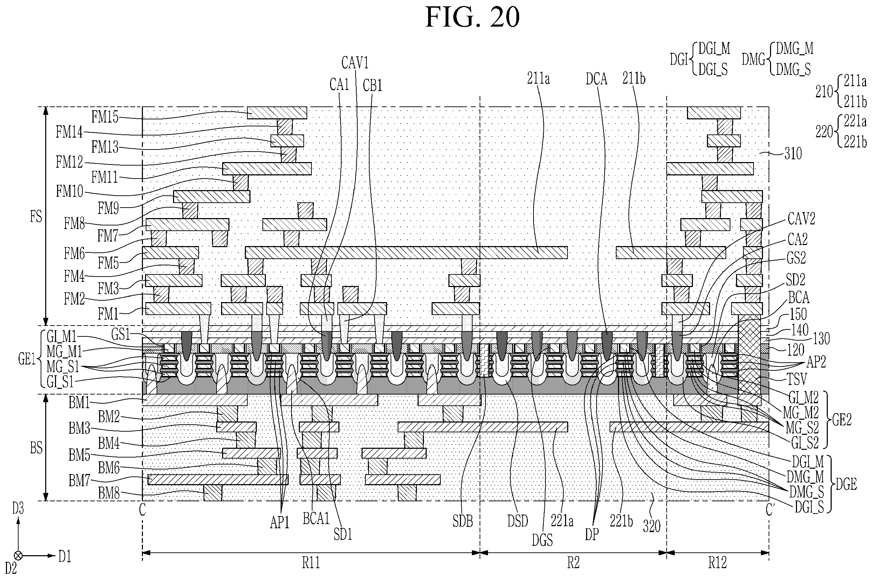

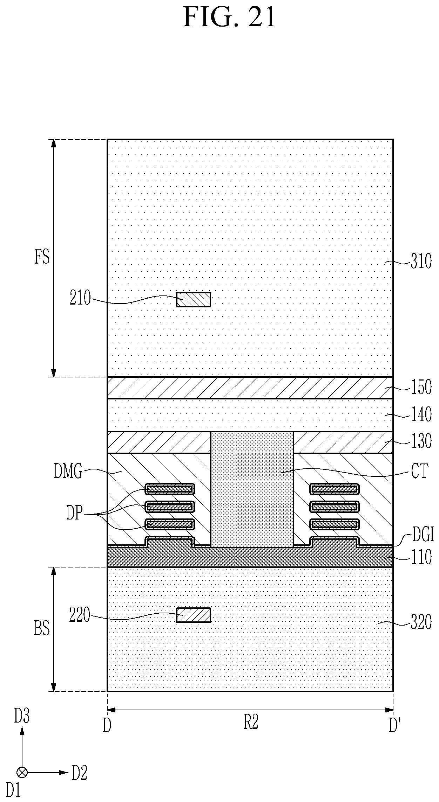

FIG. 19 is an enlarged view of a region N of FIG. 14 according to some embodiments. FIG. 20 is a cross-sectional view taken along a line A-A' of FIG. 15 according to some embodiments. FIG. 21 is a cross-sectional view taken along a line B-B' of FIG. 15 according to some embodiments.

The semiconductor devices illustrated in FIG. 19 to FIG. 21 may include components similar to or identical to the semiconductor devices described with reference to FIG. 14 to FIG. 18. However, the semiconductor device in the present embodiments is different from that illustrated in FIG. 14 to FIG. 18 in that, according to some embodiments, an element isolation layer SDB penetrating or extending into a dummy gate structure DGE positioned at both edges of the second region R2 is positioned. Here, any overlapping content from the above will be briefly explained or omitted, and the differences will be explained primarily.

According to some embodiments, the semiconductor device may include the element isolation layer SDB that physically separates the adjacent cells. According to some embodiments, the activation patterns AP1 and AP2 of the eleventh and twelfth regions R11 and R12 may be terminated by the element isolation layer SDB. Additionally, the dummy patterns DP of the second region R2 may be terminated by the element isolation layer SDB. The element isolation layer SDB may be inserted to reduce the influence between the adjacent cells, for example, a local layout effect (LLE), and to isolate impurity doped regions between the adjacent cells. According to some embodiments, the element isolation layer SDB may be composed of an insulating material.

According to some embodiments, the element isolation layer SDB may be positioned adjacent to the edge (or the boundary) of the cell. In the present disclosure, the element isolation layer SDB is shown as being a single diffusion break, but is not limited thereto and the element isolation layer SDB may also be a double diffusion break.

According to some embodiments, the element isolation layer SDB may penetrate or extend in the third direction D3 into the dummy gate structures DGEs positioned at both edges of the second region R2. The width (e.g., the length along the first direction D1) of the element isolation layer SDB may be smaller than the width of the dummy gate structure DGE or substantially the same as the width of the dummy gate structure DGE. For example, if the width (e.g., the length along the first direction D1) of the element isolation layer SDB is smaller than the width of the dummy gate structure DGE, the dummy gate structure DGE that has not been removed may be positioned around the element isolation layer SDB. For example, the same material as the dummy gate structure DGE may be positioned to be in contact with the outer side of the element isolation layer SDB. For example, if the width (i.e., the length along the first direction D1) of the element isolation layer SDB is substantially the same as the width of the dummy gate structure DGE, the element isolation layer SDB may be in direct contact with the first interlayer insulating layer 120.

According to some embodiments, the element isolation layer SDB may physically isolate both sides of the second region R2 from the regions of other adjacent cells. Accordingly, the dummy pattern DP may be removed from the part where it intersects the element isolation layer SDB. For example, the element isolation layer SDB may not overlap (or be free from overlap with) the dummy pattern DP.

According to some embodiments the element isolation layer SDB may be formed by removing the dummy gate structure DGE and at least partially filling the removed positions with an insulating material. Therefore, the element isolation layer SDB may be configured so that substantially no current flows between components positioned on both sides thereof as a reference.

Referring to FIG. 19 and FIG. 21, the semiconductor device according to some embodiments may further include a gate isolation structure CT penetrating or extending into the first gate structure GE1 and the dummy gate electrode DMG. Although not shown, the semiconductor device may further include a gate isolation structure CT penetrating or extending into the second gate structure GE2. According to some embodiments, the gate isolation structure CT may penetrate or extend into the dummy gate electrode DMG in the third direction D3.

According to some embodiments, the gate isolation structure CT may separate the dummy gate electrode DMG by cutting the dummy gate electrode DMG extending in the second direction (the direction D2) to be spaced apart from each other with the gate separation structure (CT) as the center. For example, the gate isolation structure CT may be formed of silicon nitride.

Embodiments are set out in the following Clauses:
Clause 1. A semiconductor device comprising:
   a substrate that comprises a first surface and a second surface that are opposite to each other, a cell region, and a keep out region,
   an activation pattern and a dummy pattern that are spaced apart from each other in a first direction and are on the first surface of the substrate,
   source/drain patterns and dummy source/drain patterns electrically connected to the activation pattern and the dummy pattern, respectively,
   gate electrodes and dummy gate electrodes that extend around the activation pattern and the dummy pattern, respectively, and extend in a second direction intersecting the first direction,
   an upper wire that is on the first surface of the substrate, is on the cell region, and is electrically connected to at least one first source/drain pattern of the source/drain patterns,
   a lower wire that is on the second surface of the substrate, is on the cell region, and is electrically connected to at least one second source/drain pattern of the source/drain patterns, and
   a dummy wiring extending from one of the upper wire or the lower wire,
   wherein the dummy gate electrodes and the dummy source/drain patterns are electrically insulated from the upper wire and the lower wire, and wherein the dummy wiring extends into the keep out region.
Clause 2. The semiconductor device of Clause 1, wherein:
   the substrate comprises a peripheral region that extends around the cell region,
   the activation pattern, the gate electrodes, are the source/drain patterns are on the cell region,
   the dummy pattern, the dummy gate electrodes, and the dummy source/drain patterns are on the peripheral region, and
   the keep out region is on the peripheral region.
Clause 3. The semiconductor device of Clause 1, wherein:
   the substrate comprises a plurality of cell regions that comprises the cell region, and
   each of the plurality of cell regions comprises:
      an element region comprising the activation pattern, the gate electrodes, and the source/drain patterns thereon, and
      a dummy region comprising the dummy pattern, the dummy gate electrodes, and the dummy source/drain patterns thereon, and
      the keep out region at least partially overlaps the dummy region in a third direction that is perpendicular to the first direction and the second direction.
Clause 4. The semiconductor device of Clause 3, further comprising an element isolation layer that extends into a set of the dummy gate electrodes that are respectively on edges of the keep out region.
Clause 5. The semiconductor device of Clause 3, wherein a set of the dummy gate electrodes are on edges of the keep out region.
Clause 6. The semiconductor device of any of Clauses 1-5, further comprising a plurality of upper wires that comprise the upper wire and a plurality of lower wires that comprise the lower wire, wherein a distance between the upper wire and the keep out region in the first direction is less than a distance between a second upper wire of the plurality of upper wires and the keep out region in the first direction, and wherein a distance between the lower wire and the keep out region in the first direction is less than a distance between a second lower wire of the plurality of lower wires and the keep out region in the first direction.
Clause 7. The semiconductor device of any of Clauses 1-6, wherein at least one of the gate electrodes is electrically connected to the upper wire.
Clause 8. The semiconductor device of Clause 7, wherein the dummy wiring is electrically connected to a majority of the source/drain patterns.
Clause 9. A semiconductor device
   a substrate comprising a first surface and a second surface that are opposite to each other, a first element region, a second element region, and a dummy region between the first element region and the second element region,
   a first activation pattern, a second activation pattern, and a dummy pattern that are spaced apart from each other in a first direction and are on the first surface of the first element region, the second element region, and the dummy region of the substrate, respectively,
   first source/drain patterns, second source/drain patterns, and dummy source/drain patterns that are electrically connected to the first activation pattern, the second activation pattern, and the dummy pattern, respectively,
   first gate electrodes, second gate electrodes, and dummy gate electrodes that extend around the first activation pattern, the second activation pattern, and the dummy pattern, respectively, and extend in a second direction intersecting the first direction,
   an upper wire that is on the first surface of the substrate and is electrically connected to a first set of the first source/drain patterns and a first set of the second source/drain patterns,
   a lower wire that is on the second surface of the substrate and is electrically connected to a second set of the first source/drain patterns and a second set of the second source/drain patterns, and
   a dummy wiring extending from one of the upper wire or the lower wire,
   wherein the dummy gate electrodes and the dummy source/drain patterns are electrically insulated from the upper wire and the lower wire on a portion of the dummy region, and
   wherein the dummy wiring crosses the portion of the dummy region in the first direction and is electrically connected to at least one of the first source/drain patterns and at least one of the second source/drain patterns.
Clause 10. The semiconductor device of Clause 9, wherein at least one of the first gate electrodes and at least one of the second gate electrodes are electrically connected to the upper wire.
Clause 11. The semiconductor device of Clause 10, wherein the dummy wiring is electrically connected to a majority of the first source/drain patterns and a majority of the second source/drain patterns.
Clause 12. The semiconductor device of any of Clauses 9-11, further comprising an element isolation layer that extends into a set of the dummy gate electrodes.

While this disclosure has been described in connection with what is presently considered to be practical example embodiments, it is to be understood that the disclosure is not limited to the disclosed embodiments, but, on the contrary, is intended to cover various modifications and equivalent arrangements included within the scope of the appended claims.

## Claims

1. A semiconductor device comprising:
a substrate (110) that comprises a first surface and a second surface that are opposite to each other, a cell region (CR), and a keep out region (R2),
an activation pattern (AP) and a dummy pattern (DP) that are spaced apart from each other in a first direction and are on the first surface of the substrate (110),
source/drain patterns (SD) and dummy source/drain patterns (DSD) connected to the activation pattern (AP) and the dummy pattern (DP), respectively,
gate electrodes (GE) and dummy gate electrodes (DGE) that extend around the activation pattern (AP) and the dummy pattern (DP), respectively, and extend in a second direction intersecting the first direction,
an upper wire (FM1-FM15) that is on the first surface of the substrate (110), is on the cell region, and is connected to at least one first source/drain pattern of the source/drain patterns (SD),
a lower wire (BM1-BM8) that is on the second surface of the substrate (110), is on the cell region, and is connected to at least one second source drain/pattern of the source/drain patterns (SD), and
a dummy wiring (210, 220) extending from one of the upper wire (FM1-FM15) or the lower wire (BM1-BM8),
wherein the dummy gate electrodes (DGE) and the dummy source/drain patterns (DSD) are insulated from the upper wire (FM1-FM15) and the lower wire (BM1-BM8), and wherein an end of the dummy wiring (210, 220) is on the keep out region.

2. The semiconductor device of claim 1, wherein:
the substrate (110) further comprises a peripheral region (PR) that extends around the cell region (CR),
the activation pattern (AP), the gate electrodes (GE), and the source/drain patterns (SD) are on the cell region (CR),
the dummy pattern (DP), the dummy gate electrodes (DGE), and the dummy source/drain patterns (DSD) are on the peripheral region (PR), and
the keep out region (R2) is on the peripheral region (PR).

3. The semiconductor device of claim 1, wherein:
the substrate (110) comprises a plurality of cell regions (CR) that comprises the cell region (CR), and
each of the plurality of cell regions (CR) comprises:
an element region (AR) comprising the activation pattern (AP), the gate electrodes (GE), and the source/drain patterns (SD) thereon, and
a dummy region (DR) comprising the dummy pattern (DP), the dummy gate electrodes (DGE), and the dummy source/drain patterns (DSP) thereon, and
the keep out region (R2) at least partially overlaps the dummy region (DR) in a third direction that is perpendicular to the first direction and the second direction.

4. The semiconductor device of claim 3, wherein a set of the dummy gate electrodes (DGE) are on edges of the keep out region (R2).

5. The semiconductor device of claim 4, further comprising an element isolation layer (SDB) that extends into the set of the dummy gate electrodes (DGE) that are respectively on the edges of the keep out region (R2).

6. The semiconductor device of any preceding claim, further comprising a plurality of upper wires (FM1-FM15) that comprise the upper wire (FM1-FM15) and a plurality of lower wires that comprise the lower wire, wherein a distance between the upper wire (FM1-FM15) and the keep out region (R2) in the first direction is less than a distance between a second upper wire of the plurality of upper wires (FM1-FM15) and the keep out region (R2) in the first direction, and wherein a distance between the lower wire (BM1-BM8) and the keep out region (R2) in the first direction is less than a distance between a second lower wire of the plurality of lower wires (BM1-BM8) and the keep out region (R2) in the first direction.

7. The semiconductor device of any preceding claim, wherein at least one of the gate electrodes (GE) is connected to the upper wire (FM1-FM15).

8. The semiconductor device of any preceding claim, wherein the dummy wiring (210, 220) is connected to a majority of the source/drain patterns (SD).

9. The semiconductor device of any preceding claim, wherein the dummy wiring (210, 220) extends into the keep out region (R2).

10. The semiconductor device of any preceding claim, wherein the upper wire (FM1-FM15) does not extend into the keep out region (R2).

11. The semiconductor device of any of claims 1-9, wherein the lower wire (BM1-BM8) does not extend into the keep out region (R2).

12. The semiconductor device of any preceding claim, wherein the dummy wiring (210, 220) comprises one end connected to the upper wire (FM1-FM15) or the lower wire (BM1-BM8), and the other end that is in the keep out region (R2).

13. The semiconductor device of claim 12, wherein the other end of the dummy wiring (210, 220) is electrically floating.

14. The semiconductor device of any preceding claim, further comprising a gate isolation structure (CT) penetrating into the dummy gate electrode (DGE) in a third direction that is perpendicular to the first direction and the second direction.

15. The semiconductor device of claim 14, wherein the gate isolation structure (CT) comprises silicon nitride.
